# EUROPEAN PATENT SPECIFICATION

(11) **EP 3 097 564 B1**
(45) Date of publication and mention of the grant of the patent: **19.06.2019**
(21) Application number: 15740536.6
(22) Date of filing: 22.01.2015
(51) Int. Cl.: G11C 17/18, G11C 29/04, G11C 7/10, G11C 16/10, G11C 16/26

(54) **REDUNDANCY SYSTEM FOR NON-VOLATILE MEMORY**
REDUNDANZSYSTEM FÜR NICHTFLÜCHTIGEN SPEICHER
SYSTÈME DE REDONDANCE POUR MÉMOIRE NON VOLATILE

(30) Priority: 23.01.2014 US 201414162380
(43) Date of publication of application: 30.11.2016
(73) Proprietor: Synopsys, Inc., Mountain View, CA 94043 (US)
(72) Inventor: KURJANOWICZ, Wlodek, Arnprior, Ontario K7S 3T2 (CA); ABDAT, Mourad, Ottawa, Ontario K2M 2P3 (CA)
(74) Representative: V.O.
(86) International application number: PCT/CA2015/050040
(87) International publication number: WO 2015/109404

(56) References cited:
- CA-A1- 2 708 593
- US-A1- 2011 019 491
- US-A1- 2012 131 418
- US-A1- 2012 131 418
- US-B1- 6 570 795

## Description

### FIELD OF THE INVENTION

The present invention relates generally to non-volatile memories. More particularly, the present invention relates to a redundancy scheme for non-volatile memories.

### BACKGROUND OF THE INVENTION

Anti-fuse memories are considered a non-volatile memory in which data is retained in the memory cell in the absence of power. An anti-fuse device is a structure alterable to a conductive state, or in other words, an electronic device that changes state from non-conducting to conducting. Equivalently, the binary states can be either one of high resistance and low resistance in response to electric stress, such as a programming voltage or current. Unlike other forms of non-volatile memory such as flash, ferro-electric and magnetic memories, the anti-fuse programming is intended to be irreversible. Hence anti-fuse memories are referred to as one time programmable (OTP) memories.

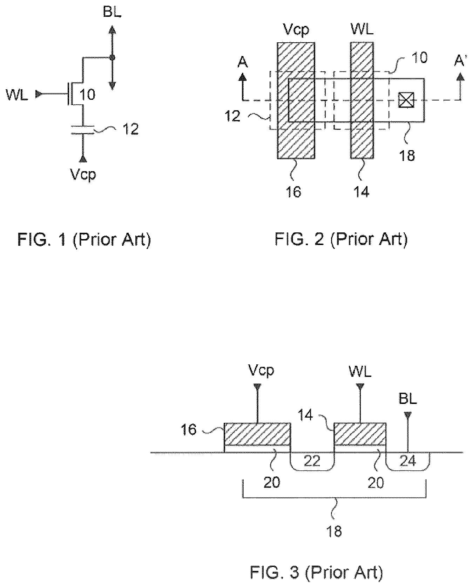

A DRAM-type memory array using a planar capacitors as an anti-fuse instead of as a storage capacitor is already known, as demonstrated in U.S. Patent No. 6,667,902. Figure 1 is a circuit diagram of such a memory cell, while Figures 2 and 3 show the planar and cross-sectional views respectively, of the known anti-fuse memory cell of Figure 1. The memory cell of Figure 1 includes a pass, or access transistor **10** for coupling a bitline BL to a bottom plate of anti-fuse device **12.** A wordline WL is coupled to the gate of access transistor **10** to turn it on, and a cell plate voltage Vcp is coupled to the top plate of anti-fuse device **12** for programming anti-fuse device **12.**

It can be seen from Figures 2 and 3 that the layout of access transistor **10** and anti-fuse device **12** is very straight-forward and simple. The gate **14** of access transistor **10** and the top plate **16** of anti-fuse device **12** are constructed with the same layer of polysilicon, which extend across active area **18.** In the active area **18** underneath each polysilicon layer, is formed a thin gate oxide **20,** also known as a gate dielectric, for electrically isolating the polysilicon from the active area underneath. On either side of gate **14** are diffusion regions **22** and **24,** where diffusion region **24** is coupled to a bitline. Although not shown, those of skill in the art will understand that standard CMOS processing, such as sidewall spacer formation, lightly doped diffusions (LDD) and diffusion and gate silicidation, can be applied. While the classical single transistor and capacitor cell configuration is widely used, a transistor-only anti-fuse cell is further desirable due to the semiconductor array area savings that can be obtained for high-density applications. Such transistor-only anti-fuses must be reliable while simple to manufacture with a low cost CMOS process.

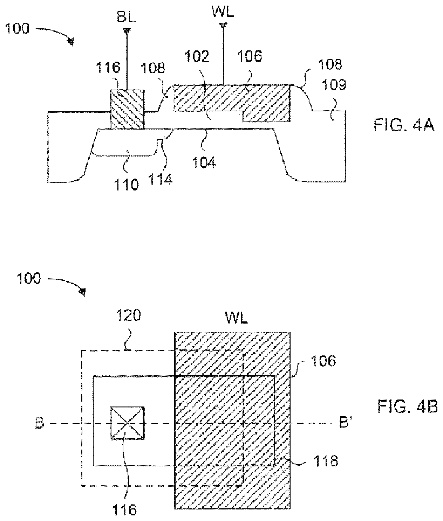

According to an embodiment of the present invention, Figure 4A shows a cross-sectional view of an anti-fuse transistor that can be manufactured with any standard CMOS process. In the presently shown example, the anti-fuse transistor is almost identical to a simple thick gate oxide, or input/output MOS transistor with one floating diffusion terminal. The disclosed anti-fuse transistor, also termed a split-channel capacitor or a half-transistor, can be reliably programmed such that the fuse link between the polysilicon gate and the substrate can be predictably localized to a particular region of the device. The cross-section view of Figure 4A is taken along line B-B' of Figure 4, being along the channel length of the device, which in the presently described embodiment is a p-channel device. Those of skill in the art will understand that the present invention can be implemented as an n-channel device.

Anti-fuse transistor **100** includes a variable thickness gate oxide **102** formed on the substrate channel region **104,** a polysilicon gate **106,** sidewall spacers **108,** a field oxide region **109** a diffusion region **110,** and an LDD region **114** in the diffusion region **110.** A bitline contact **116** is shown to be in electrical contact with diffusion region **110.** The variable thickness gate oxide **102** consists of a thick oxide and a thin gate oxide such that a portion of the channel length is covered by the thick gate oxide and the remaining portion of the channel length is covered by the thin gate oxide. Generally, the thin gate oxide is a region where oxide breakdown can occur. The thick gate oxide edge meeting diffusion region **110** on the other hand, defines an access edge where gate oxide breakdown is prevented and current between the gate **106** and diffusion region **110** is to flow for a programmed anti-fuse transistor. While the distance that the thick oxide portion extends into the channel region depends on the mask grade, the thick oxide portion is preferably formed to be at least as long as the minimum length of a high voltage transistor formed on the same chip.

In a preferred embodiment, the diffusion region **110** is connected to a bitline through a bitline contact **116,** or other line for sensing a current from the polysilicon gate **106,** and can be doped to accommodate programming voltages or currents. This diffusion region **110** is formed proximate to the thick oxide portion of the variable thickness gate oxide **102.** To further protect the edge of anti-fuse transistor **100** from high voltage damage, or current leakage, a resistor protection oxide (RPO), also known as a salicide protect oxide, can be introduced during the fabrication process to further space metal particles from the edge of sidewall spacer **108.** This RPO is preferably used during the salicidiation process for preventing only a portion of diffusion region **110** and a portion of polysilicon gate **106** from being salicided.

It is well known that salicided transistors are known to have higher leakage and therefore lower breakdown voltage. Thus having a non-salicided diffusion region **110** will reduce leakage. Diffusion region **110** can be doped for low voltage transistors or high voltage transistors or a combination of the two resulting in same or different diffusion profiles.

A simplified plan view of the anti-fuse transistor **100** is shown in Figure 4B. Bitline contact **116** can be used as a visual reference point to orient the plan view with the corresponding cross-sectional view of Figure 4A. The active area **118** is the region of the device where the channel region **104** and diffusion region **110** is formed, which is defined by an OD mask during the fabrication process. The dashed outline **120** defines the areas in which the thick gate oxide is to be formed via an OD2 mask during the fabrication process. More specifically, the area enclosed by the dashed outline **120** designates the regions where thick oxide is to be formed. OD simply refers to an oxide definition mask that is used during the CMOS process for defining the regions on the substrate where the oxide is to be formed, and OD2 refers to a second oxide definition mask different than the first.

Programming of anti-fuse transistor **100** is based on gate oxide breakdown to form a permanent link between the gate and the channel underneath. Gate oxide breakdown conditions (voltage or current and time) depend primarily on i) gate dielectric thickness and composition, ii) defect density, and iii) gate area, gate/diffusion perimeter. The combined thick and thin gate oxide of anti-fuse transistor **100** results in a locally lowered gate breakdown voltage, in particular an oxide breakdown zone, in the thin gate oxide portion of the device. Anti-fuse transistor **100** is but one type of anti-fuse device which can be used in an OTP memory. Those skilled in the art will understand that different types of anti-fuse devices are programmed in a similar manner.

As with any fabricated semiconductor memory device, random defects can occur during manufacturing. More specifically, memory cells can suffer from physical defects that alter its characteristics. Such defects can render the OTP memory inoperable, since data may not be reliably stored in the defective cells. In a newly manufactured anti-fuse memory array, all the cells should be read as having an unprogrammed logic state. For example, an unprogrammed state logic state can correspond to a "0". However, due to manufacturing defects, some of the anti-fuse cells will leak current. In the present example, anti-fuse cells which leak current will read as a logic "1" state, which corresponds to a programmed state of the cell. These types of defective cells are referred to as leaky cells. Conversely, some anti-fuse cells may be difficult to program, thereby reading out a logic "0" state when it should be reading out as a logic "1" state. These types of defective cells are referred to as weak cells.

In order to improve overall manufacturing yield, redundancy schemes have been developed to repair memory arrays having defective cells. A well known redundancy technique of replacing rows and/or columns containing a defective cell with spare rows and/or columns can be used. However, such techniques introduce significant logic overhead for re-routing addresses while trying to ensure transparent operation and minimum diminished performance to the end user.

Examples of prior redundancy schemes are disclosed in the following US patents. In US Patent No. 6,421,799, a redundant ROM stores parity bits for rows and columns of main memory. A testing circuit calculates a parity for each row and column. In US Patent No. 6,944,083 a good copy of the sensitive data is stored in a different physical location. If tampering of memory is detected by comparing data stored in main memory with data stored in redundancy, data in the main memory is identified as unusable and data retrieved from redundant memory is used instead. In US Patent No. 7,047,381 multistage programming is implemented in the OTP array with use of the redundant rows. In US Patent No. 7,003,713 an OTP module receives encoded host data from the host integrated circuit and provides a copy of corrected host data to the host integrated circuit.

U.S. Patent Application Publication No. 2011/0019491 discloses a redundancy scheme for Non-Volatile Memories (NVM). This redundancy scheme provides means for using defective cells in non-volatile memories to increase yield. The algorithm is based on inverting the program data for data being programmed to a cell grouping when a defective cell is detected in the cell grouping. Defective cells are biased to either "1" or "0" logic states, which are effectively preset to store its biased logic state. A data bit to be stored in a defective cell having a logic state that is complementary to the biased logic state of the cell results in the program data being inverted and programmed. An inversion status bit is programmed to indicate the inverted status of the programmed data. During read out, the inversion status bit causes the stored data to be re-inverted into its original program data states. In one example, two inversion status cells can be for respective segments of an n-bit data cell group/word.

Most redundancy schemes require significant additional logic, which ultimately increases the chip area or macro footprint. Therefore a new redundancy scheme that minimizes logic overhead while maximizing overall yield is needed.

### SUMMARY OF THE INVENTION

In a first aspect, there is provided a non-volatile memory as defined in claim 1.

In the present embodiments, the first logic circuitry can include AND logic or Exclusive OR (XOR) logic.

In some embodiments, the at least two inversion status cells can include three inversion status cells or greater than three inversion status cells.

In an embodiment, the second logic circuitry includes XOR logic corresponding to each entry of the n-bit entry. In some embodiments, the XOR logic for each entry of the n-bit entry includes a first input for receiving a logic state corresponding to one bit of the n-bit entry, a second input for receiving the inversion control signal, and an output for providing an inversion of the logic state received at the first input in response to the inversion control signal.

In a second aspect, there is provided a redundancy method for a non-volatile memory as defined in claim 7.

In one embodiment, the method can further include programming the memory cells with one of the logic states of the program data and the inverted logic states of the program data, and programming the plurality inversion status cells with the logical combination of specific and permanent logic states. In some embodiments, the method also further includes reading the memory cells, reading the plurality of inversion status cells, and inverting read data of the memory cells when the logical combination of specific and permanent logic states indicates the read data was programmed in an inverted state.

In an embodiment, inverting includes executing a logical operation on the logical combination of specific and permanent logic states to provide an inversion control signal, and executing an inversion operation on the read data in response to the inversion control signal.

In various embodiments, the logical combination is an AND operation or an Exclusive Or (XOR) operation.

In various embodiments, the plurality of inversion status cells can include two inversion status cells, three inversion status cells, or greater than three inversion status cells.

Other aspects and features of the present invention will become apparent to those ordinarily skilled in the art upon review of the following description of specific embodiments of the invention in conjunction with the accompanying figures.

### BRIEF DESCRIPTION OF THE DRAWINGS

Embodiments of the present invention will now be described, by way of example only, with reference to the attached Figures, wherein:
Fig. 1 is a circuit diagram of a DRAM-type anti-fuse cell;
Fig. 2 is a planar layout of the DRAM-type anti-fuse cell of Figure 1;
Fig. 3 is a cross-sectional view of the DRAM-type anti-fuse cell of Figure 2 along line A-A';
Fig. 4A is a cross-sectional view of the anti-fuse transistor of Figure 4B, according to an embodiment of the present invention;
Fig. 4B is a planar layout of the anti-fuse transistor of Figure 4A;
Fig. 5 is a drawing illustrating an n-bit entry having a defective cell and its corresponding inversion status bit, not forming part of the present invention;
Figs. 6A, 6B and 6C are drawings illustrating example redundancy operations, not forming part of the present invention;
Fig. 7 is a block diagram of a memory having a redundancy system, not forming part of the present invention;
Fig. 8 is a circuit schematic of a portion of the memory array and circuits of the sense amplifier circuit block shown in Figure 7;
Fig. 9 is a circuit schematic of an n-bit self-inverting data register of Figure 7, not forming part of the present invention;
Fig. 10 is a circuit schematic of a single bit self-inverting register cell of the n-bit self-inverting data register of Figure 7, not forming part of the present invention;
Fig. 11 is a circuit schematic of the inversion status bit register, not forming part of the present invention;
Fig. 12 is a flow chart of a general method for operating an OTP memory having a redundancy scheme, not forming part of the present invention;
Figs. 13A and 13B is an embodiment of the method shown in Figure 12, not forming part of the present invention;
Fig. 14 is an example showing the presently described redundancy technique applied to a memory array, not forming part of the present invention;
Fig. 15 is an alternate example showing the presently described redundancy technique applied to a memory array, not forming part of the present invention;
Fig. 16 is another alternate example showing the presently described redundancy technique applied to a memory array, not forming part of the present invention;
Figs. 17A and 17B illustrate schematic diagrams of a circuit utilizing a plurality of inversion status cells, according to a present embodiment;
Figs. 18A and 18B illustrate schematic diagrams of an alternate circuit utilizing a plurality of inversion status cells, according to a present embodiment;
Figs. 19A and 19B illustrate schematic diagrams of another alternate circuit utilizing a plurality of inversion status cells, according to a present embodiment; and
Fig. 20 is a flow chart diagram illustrating a method of utilizing a plurality of inversion status cells, according to a present embodiment.

### DETAILED DESCRIPTION

Generally, the present invention provides a redundancy scheme for non-volatile memories, such as OTP or electrically erasable memories such as EPROM and Flash memories. The redundancy scheme uses defective cells in non-volatile memories to increase yield by using the defective cells to store data. The algorithm can be made transparent for user application during programming and during read operations. After manufacturing, an array clean test is performed prior to shipment of the memory devices. This test identifies those memory cells which tend to leak more than the allowed design permits. The identified leaky cells are programmed as logic "1" states, since they are read out as logic "1" states in the unprogrammed state. Alternately, cells which are difficult to program are retained as logic "0" states, since they cannot be programmed to the logic "1" state. Hence these defects are referred to as biased logic states of the cells. Each grouping of cells being an 8-bit word or a word having any number of bits, includes at least one additional cell used as an inversion status tag bit to indicate that the stored data entry uses a biased logic state to store a bit of the data entry.

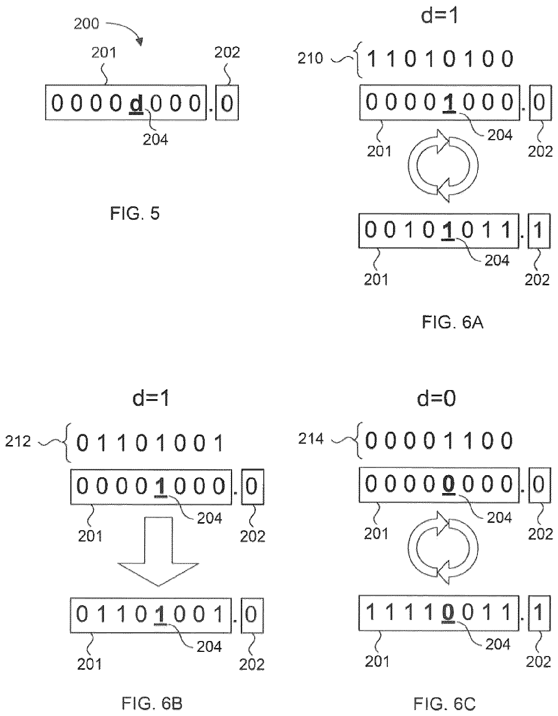

The general principle of the presently described redundancy technique is now discussed with reference to Figure 5. Figure 5 is a drawing illustrating a cell group **200** consisting of an n-bit data cell group **201,** where n can be any integer value greater than 1, and a corresponding inversion status cell **202.** The cell group **200** stores data, which consists of program data and an inversion status bit. In the present example of Figure 5, data cell group **201** is 8-bits where either the left-most bit or the right-most bit is the least significant bit (LSB). In Figure 5, the decimal point is used to visually distinguish data cell group **201** from the inversion status cell **202.** It is assumed that all memory cells of data cell group **201** and inversion status cell **202** have a default unprogrammed logic state of "0" or erased logic state of "0". In this example, a defective cell **204** is detected in data cell group **201,** marked with the letter "d".

According to the present embodiments, d can be permanently set to its biased logic state. For example, if defective cell **204** is a leaky OTP cell that tends to read out as a logic "1" while unprogrammed instead of the proper logic "0", then d is set to "1" by programming defective cell **204.** Next, when 8-bit data is programmed to data cell group **201,** the set logic "1" state of defective cell **204** is compared to the program data bit to be stored within it. If the program data bit mismatches the set logic state of defective cell **204,** then all bits of the program data are inverted for programming into data cell group **201.** Additionally, the default logic state of the inversion status bit is inverted and programmed into the inversion status cell **202.** Otherwise, no inversion of the program data is required. Therefore, the defective cell **204** is reclaimed and the data cell group **201** is repaired as the defective cell **204** is re-used to store a data bit. It is noted that data to be stored in the cell group **200** of Figure 5 includes the program data to be stored in the data cell group **201** and inversion status data to be stored in the inversion status cell **202.** If there are no cell defects or no inversion is required, then the inversion status cell **202** remains in a default unprogrammed state, which corresponds to a logic "0" in the present examples.

Figures 6A, 6B and 6C are examples illustrating the presently described redundancy technique, where the program data has a bit matching and mismatching the set logic state of the defective cell of a data cell group **201.** In Figure 6A, data cell group **201** of Figure 5 has defective cell **204** permanently set to a "1" logic state (d=1), and program data **210** received by the memory device is to be stored in data cell group **201.** Counting from the right side of data cell group **201,** defective cell **204** is bit position 4 while bit position 4 of program data **210** is a logic "0". In order to reliably store program data **210** in data cell group **201,** and due to the mismatch between bit position 4 of the data cell group **201** and bit position 4 of the program data **210,** all bits of the data which includes program data **210** and the inversion status bit are inverted. The inversion process is illustrated by the circular arrows, and the resulting data stored by data cell group **201** is shown at the bottom of Figure 6A. Because the data cell group **201** stores inverted program data, the inversion status cell **202** is programmed to a "1" logic state. This "true" logic state indicates that the data stored in data cell group **201** is inverted relative to its original version. The data stored in the inversion status cell **202** is referred to as an inversion status bit, which is used later during a read operation whereby the data is re-inverted back to its original state. Therefore, by storing an inverted version of the received program data in the data cell group **201,** the defective cell **204** is reclaimed thereby allowing data cell group **201** to be used even though it has a detective cell **204.**

Figure 6B shows an example where different program data **212** is to be programmed to data cell group **201** shown in Figure 6A. In this example, bit position 4 of the program data and bit position 4 of the data cell group **201** are both logic "1", and therefore match. No inversion of program data **212** is required, and the program data is directly stored in data cell group **201** as shown by the straight arrow. Figure 6C shows an example where the defective cell **204** is set to a logic "0". It is assumed that the bit position 4 of data cell group **201** is known to have the defective cell set to logic "0". Since bit position 4 of program data **214** is a logic "1", there is a mismatch. Accordingly, all bits of program data **214** is inverted and stored in data cell group **201** while inversion status cell **202** is programmed to a logic "1" to indicate that the corresponding data cell group **201** stores inverted program data.

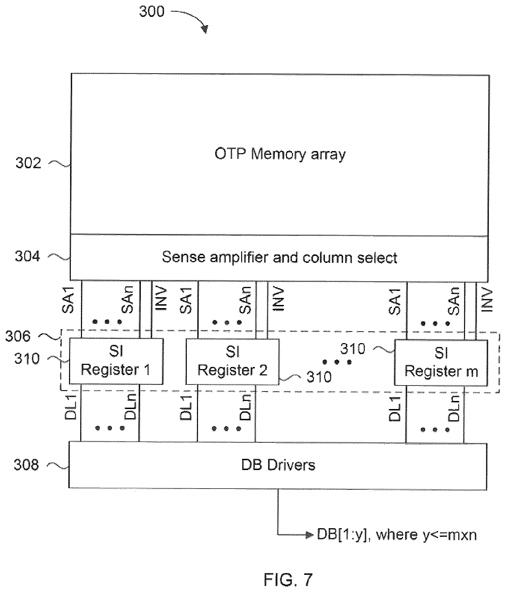

Now that the redundancy concept of the present invention has been described, following is a description of a memory device or memory macro having the presently described redundancy scheme. Subsequent reference to a memory device should be understood to include a memory macro. A memory macro is an instance of the memory circuits which can be integrated into an embedded chip or system. Figure 7 is a block diagram of a memory having a redundancy system, according to a present embodiment. The memory can be any non-volatile memory, but is now described within the context of an OTP memory. The memory device **300** includes an OTP memory array **302,** sense amplifier and column select circuitry **304,** a data register **306** and databus drivers **308.** The data register **306** includes individual self-inverting (SI) data register **310.** Each self-inverting data register **310** corresponds to one cell group, such as the n-bit +1 cell group **200** shown in Figures 5 and 6A, 6B and 6C.

The OTP memory array **302** includes bitlines and wordlines connected to OTP memory cells, such as the OTP anti-fuse transistor device **100** shown in Figures 4A and 4B. The bitlines are sensed by sense amplifier circuits in sense amplifier and column select circuitry **304,** which can include column select circuits for multiplexing one of a multiple of bitlines to one sense amplifier circuit, as is well known in the art. Each sense amplifier circuit of sense amplifier and column select circuitry **304** provides 1 bit of sensed read data for storage by latch circuits in SI data register **310.** In the present example, each of the sense amplifier circuits also receives 1 bit of program data from latch circuits in SI data register **310.** In Figure 7, each sense amplifier circuit provides 1 bit of read data and receives 1 bit of program data via a pair of SA lines, where each pair is shown as single line SA. In the present example configuration, each SI data register **310** receives SA1 to SAn, where n corresponds to the size of the n-bit data cell group **201.** There can be up to m SI data registers **310,** where m is an integer value. Each SI data register **310** further receives and provides an inversion status bit INV. As previously mentioned, each SI data register **310** corresponds to an n-bit +1 cell group. As will be described in further detail later, each SI data register **310** can invert all the bits of its received program data in the event the aforementioned mismatch condition is detected for programming, and can re-invert all the read data bits in response to the inversion status bit INV in a read operation.

Each SI data register **310** receives program data from a write databus (not shown) and provides read data via datalines DL1 to DLn. It is noted that input and output datalines for 1 bit are represented by a single dataline. The databus drivers **308** perform a well known function of driving a databus DB[1:y], where y<=mxn. The width of DB depends on the configuration of memory device **300.** Additional multiplexing circuitry can be included within the block of databus drivers **308** for coupling any set of datalines DL1 to DLn if the width of DB is less than mxn. According to the present embodiments, the inversion status bit INV is local to an SI data register **310** and the memory array, and is therefore not output in a manner similar to read data, nor is it received in a manner similar to program data.

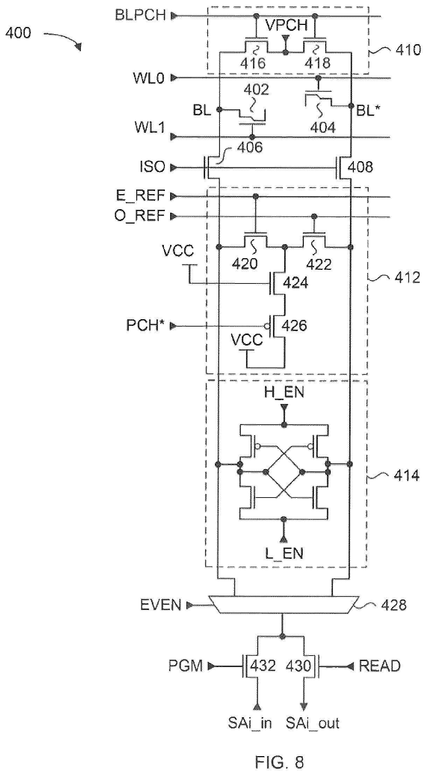

Figure 8 is a schematic of a portion of memory array **302** of Figure 7 and its associated bitline sensing circuitry located in sense amplifier and column select circuitry block **304.** In the present example, memory array **302** is organized in a folded bitline architecture, which is well known in the art. In order to simplify the schematic, only one folded bitline pair BL/BL* and two wordlines are shown. Column decoder circuitry is not shown for selectively coupling multiple folded bitline pairs to the bitline sense amplifier circuitry in order to simplify the schematic. Folded bitline memory array **400** includes wordlines WL0 and WL1 connected to the gate terminals of OTP memory cells, implemented in the present example as n-channel anti-fuse transistors **402** and **404,** n-channel isolation transistors **406** and **408** for coupling the upper portion of the bitlines to the lower portion of the bitlines in response to signal ISO, and bitline sensing circuitry. The bitline sensing circuitry includes a precharge circuit **410,** a reference charge circuit **412,** and a bitline sense amplifier **414.**

The precharge circuit **410** includes two n-channel precharge transistors **416** and **418** connected in series between BL and BL* and having their gate terminals connected to precharge signal BLPCH. The shared source/drain terminal of precharge transistors **416** and **418** receives a precharge voltage VPCH. In operation, both precharge transistors **416** and **418** will turn on to precharge bitlines BL and BL* to VPCH in response to an active high logic level of BLPCH, in preparation for a read operation.

The reference charge circuit **412** includes n-channel steering transistors **420** and **422** connected in series between BL and BL*, a capacitance circuit implemented as an n-channel transistor **424,** and a p-channel precharge transistor **426.** Steering transistor **420** has its gate terminal connected to even selection signal E_REF, while steering transistor **422** has its gate terminal connected to odd selection signal O_REF. Capacitance circuit **424** has its gate terminal connected to voltage supply VCC, and is connected in series with precharge transistor **426** between the shared source/drain terminal of steering transistors **420** and **422** and voltage supply VCC. Precharge transistor **426** has its gate terminal connected to a precharge or enable signal PCH*. Generally, capacitance circuit **424** will be precharged when a low logic level PCH* pulse is received. The duration of the PCH* pulse can be predetermined based on the size of transistor **424** and the desired reference charge to be provided. Once precharged, either steering transistor **420** or **422** is turned on to couple the reference charge of capacitance circuit **424** to the corresponding bitline. By example, the charge being added to a bitline can be approximately 50 millivolts. It is noted that signals E_REF and O_REF can be controlled by the same even/odd addressing bit used for selecting WL0 or WL1. In one embodiment, activation of WL0 will cause E_REF to be activated, thereby coupling the reference charge to the complementary bitline.

The bitline sense amplifier **414** consists of a standard cross-coupled inverter circuit which is well known in the art. The circuit includes p-channel transistors both connected in series to respective n-channel transistors. The common drain terminal of the p-channel transistors receives a high logic level enable signal H_EN, while the common source terminal of the n-channel transistors receives a low logic level enable signal L_EN. H_EN can be a lowered internal VCC level, while L_EN can be a VSS level. The operation of bitline sense amplifier **414** in the DRAM art is well known. When enable signals H_EN and L_EN are activated, either at the same time or at different times, bitline sense amplifier **414** will sense a small voltage differential between BL and BL*, and quickly drive both BL and BL* to the full logic level states of H_EN and L_EN.

Because bitline sense amplifier **414** is connected to both bitlines BL and BL*, the logic state being programmed or read from the memory array will depend on the memory cell that is accessed. For example, if both anti-fuse transistors **402** and **404** store a logic "1", bitline sense amplifier **414** will latch two different logic states depending on which anti-fuse transistor is accessed. Therefore, a data state corrector **428** is used for ensuring that the voltage level corresponding to logic "1" and "0" states is read and programmed. In the present example, if WL0 is activated to read anti-fuse transistor **404,** then signal EVEN will be at the logic state for coupling BL* to gating transistor **430.** Alternately, of WL1 is activated to read anti-fuse transistor **402,** then signal EVEN will be at the opposite logic state for coupling BL to gating transistor 430. The operation of data state corrector **428** is similar when program data is to be coupled to either BL or BL* from gating transistor **432.** Data state corrector **428** can be implemented as a simple bi-directional multiplexor controlled by signal EVEN, which can be related to the address used to select wordline WL0 and WL1. Signal EVEN can be related to signals E_REF and O_REF as well. Data to be programmed to the bitlines is provided through n-channel gating transistor **432** which is coupled to SAi_in and controlled by program signal PGM. Data to be read from the bitlines is provided through n-channel gating transistor **430** which is coupled to SAi_out and controlled by read signal READ. It is noted that signals SAi_in and SAi_out correspond to the previously discussed pair of SA lines. Accordingly, gating transistor **432** is turned on during a program operation while gating transistor **430** is turned on during a read operation. Variable "i" is an integer value between 1 and max number n.

The memory array architecture and circuits of Figure 8 is one example of a non-volatile memory array configuration which can be used in the embodiments of the present invention, and the presently described redundancy scheme is not limited to the memory array configuration of Figure 8. The memory array architecture of Figure 8, and in particular the configuration whereby separate sense amplifier input and output paths SAi_in and SAi_out, facilitates the design and operation of the self-inverting register circuits.

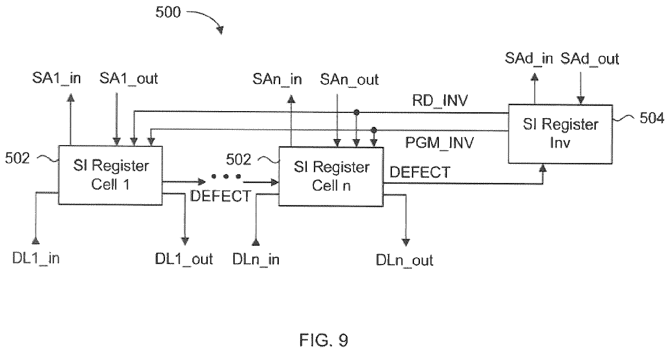

Figure 9 is a block diagram showing one SI data register **310** of Figure 7 according to a present embodiment. SI data register **500** includes one SI register cell **502** for each bit of data to be programmed or read out from memory array **302,** and an SI register cell **504** for the inversion status bit. The SI register cells **502** are labeled Cell 1 to Cell n, to correspond to the n-bit data cell group **201.** As shown in Figure 9, each SI register cell **502** provides 1 bit of program data via an SAi_in line to a sense amplifier and receives 1 bit of read data via an SAi_out line (where i=1 to n) from the sense amplifier. The 1 bit of program data is provided by a DLi_in line, while the 1 bit of read data is output from the register cell by a DLi_out line.

As part of a program operation, each SI register cell **502** is configured to compare the logic state of its received program data bit against the logic state of the cell it is to be programmed to. In the previously discussed example, a cell set to a logic "1" is a leaky defective cell. In the case of a mismatch, a mismatch flag DEFECT is provided and cascaded through the SI register cells. In otherwords, each SI register cell **502** logically OR's its mismatch flag result to that provided by a previous SI register cell **502.** The final DEFECT flag indicates if one of the SI register cells **502** reported a mismatch, and is received by SI register cell **504** which checks to see if the inversion status cell is defective or not. If one SI register cell **502** reports a mismatch or SI register cell **504** reports that the inversion status cell is defective, then a program inversion signal PGM_INV provided by SI register cell **504** is set to an active logic level. All SI register cells **502** receive PGM_INV, and are configured to invert their program data bits in response to the active logic level of PGM_INV. Then the inverted program data is programmed into the corresponding cells of the data cell group. In the present example, the inverted program data is provided to the sense amplifier circuit via respective SAi_in lines. Also, the inversion status bit is set and the corresponding inversion status cell is programmed to indicate that the program data has been inverted.

In a read operation, the all SI register cells **502** receive read data from its respective SAi_out line, and SI register cell **504** receives the logic state of the inversion status bit read from the corresponding inversion status cell. If the inversion status bit is at a logic level indicating that the program data has been inverted, then read inversion signal RD_INV is set to an active logic level. All SI register cells **502** receive RD_INV, and are configured to invert their read data bits in response to the active logic level of RD_INV. Therefore the original program data is restored and output to the databus drivers. Accordingly, the SI register cells **502** and **504** can invert either the program data bits or read data bits within the register cell itself.

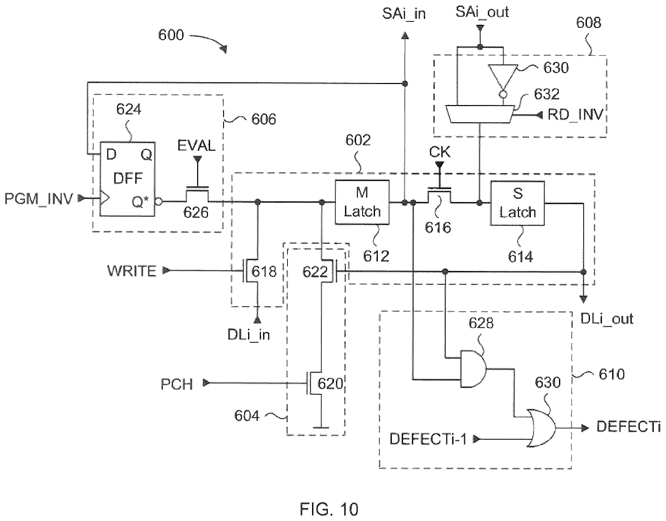

Figure 10 is a circuit schematic of the SI register cell **502** shown in Figure 9, according to a present embodiment. It is noted that SI register cell **600** includes many of the same circuits as the dual function shift register circuit disclosed in PAT 3672W-90. In order to simplify the schematic several circuits are intentionally omitted.

SI register cell **600** includes a data storage circuit **602,** an auto-program inhibit circuit **604,** a program data inversion circuit **606,** a read data inversion circuit **608** and data mismatch comparison logic **610.** It is recalled that variable "i" in the signal names denotes the specific register cell it is associated with.

Data storage circuit **602** is responsible for data input, output and latching operations. Data storage circuit **602** includes a master latch **612** and a slave latch **614** connected as a master-slave flip-flop, transfer gating device **616,** and an input gating device **618.** Latches **612** and **614** can be implemented as simple cross-coupled inverter circuits with a non-inverting output relative to its input, but slave latch **614** is configured to be overwritten by master latch **612.** Those skilled in the art will understand that transistor sizing can be configured to achieve this desired function. Gating device **616** is shown as an n-channel transistor, but can be replaced with a transmission gate or a p-channel transistor. Gating device **616** has its gate terminal connected to clock signal CK, which is a controlled clock signal to shift data serially from the master latch **612** to slave latch **614.** Input data DLi_in is provided to the input of master latch **612** via gating device **618** when signal WRITE is at the active logic level, which in the present example is the high logic level. Output data DLi_out is provided from the output of slave latch **614.** The output of master latch **612,** typically being program data, is coupled to a sense amplifier via terminal SAi_in, while read data from the sense amplifier is provided from terminal SAi_out and stored by slave latch **614.**

The auto-program inhibit circuit **604** is used to verify if a programming operation was successful or not. The auto-program inhibit circuit **604** includes a precharge device **620** and a coupling device **622** connected in series between a voltage supply such as VDD and the input of master latch **612.** Both devices **620** and **622** are shown as being n-channel transistors in the present embodiment. The gate of precharge device **620** is connected to precharge signal PCH and the gate of coupling device **622** is connected to the output of slave latch **614.** The selection of the voltage supply depends on the logic state stored by master latch **612** for selecting a memory cell to be programmed. For example, if master latch **612** stores a logic 0 (VSS) to indicate programming of the memory cell connected to that bitline, then the voltage supply connected to precharge device **620** will be VDD. Hence, VDD is the logic state stored in a master latch **612** for a memory cell that is not to be programmed, thereby inhibiting programming of the cell connected to that bitline. The auto-program inhibit circuit will therefore change the state of the master latch **612** if the memory cell was successfully programmed. In the present example, a successfully programmed memory cell will result in slave latch **614** storing a high a logic state in a program verify read operation following a program operation. Therefore, when PCH is driven to the high logic level, VDD is coupled to the input of master latch **612** to flip its state.

The program data inversion circuit **606** includes a flip-flop circuit **624** and a coupling device **626** controlled by an evaluation signal EVAL. Flip-flop circuit **624** has a D-input receiving program data latched by master latch **612** (SAi_in), and has a non-inverting output (Q) and an inverting output (Q*), where the inverting output is connected to one terminal of the coupling device **626.** The other terminal of the coupling device **626** is connected to an input of master latch **612,** while its gate terminal receives EVAL. Flip-flop circuit **624** latches the data appearing on its D-input and provides the inverted version thereof on its inverting output Q* in response to an active logic state of PGM_INV received at its clock input. Therefore, if the program data is to be inverted, PGM_INV is driven to the active logic level and EVAL can be pulsed to briefly turn on coupling device **626** to electrically connect the inverting output Q* to the input of master latch **612.** Therefore the logic state of master latch **612** is inverted. The pulse duration of EVAL can be selected to be at least long enough to ensure that master latch **612** is over-written or flipped.

The data mismatch comparison logic **610** is used in conjunction with program data inversion circuit **606,** and includes an AND logic gate **628** and an OR logic gate **630.** AND logic gate **628** has a first input receiving an output of slave latch **614** and a second input receiving an output of master latch **612.** The purpose of AND logic gate **628** is to detect the condition where a logic "0" is to be programmed to a defective cell set to permanent store a logic "1". As previously discussed for the present example, a logic "1" stored in master latch **612** inhibits programming, thereby storing a logic "0" in the selected cell. However, if the selected cell has been previously determined to be defective and preset to store a logic "1", then there is a mismatch between the data to be stored and the preset logic state of the cell. This mismatch condition is detected by AND logic gate **628** when both master latch **612** and slave latch **614** store a logic "1". Therefore AND logic gate **628** outputs a logic "1" output, which can be referred to as a local DEFECT flag signal, which is then combined with a global DEFECT flag signal DEFECTi-1 provided from a previous SI register cell **502** at OR logic gate **630.** The output of OR logic gate **630** is the updated global flag signal DEFECTi that is provided to the next SI register cell **502,** or the SI register cell **504.** If SI register cell **600** is the first register cell, then its OR logic gate **630** has one input tied to ground or VSS as there is no previous SI register cell to report a defect. Later, if DEFECTi is at the active logic level, which in the present example is a logic "1", then PGM_INV is set to the active logic level to enable inversion of the program data.

The read data inversion circuit **608** is connected between SAi_out and the input of slave latch **614,** and includes a selector **632** and an inverter **634.** Selector **632** is shown as a multiplexor having a first input for receiving SAi_out and a second input for receiving an output of inverter **634,** where inverter **634** has its input connected to SAi_out. Selector **632** passes data from either its first input or second input, to its output in response to signal RD_INV, which functions as a selection signal. In its default inactive logic state, RD_INV control selector **632** to pass SAi_out directly to slave latch **614.** In its active logic state, where the read data is to be inverted, selector **632** passes the output of inverter **634** to slave latch **614.** Therefore an inverted version of SAi_out is stored in slave latch **614.**

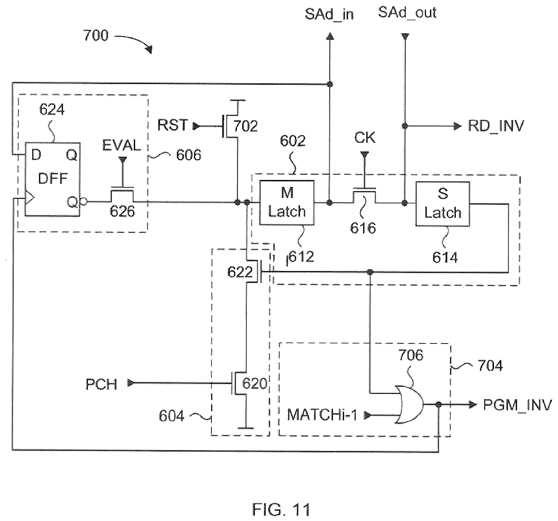

Figure 11 is a circuit schematic of the SI register cell **504** of Figure 9, according to a present embodiment. SI register cell **700** includes many of the same circuits as shown for SI register cell **600** of Figure 10. In particular, circuits **602, 604** and **606** are the same as those previously described for SI register cell **600.** SI register cell **700** does not have input gating device **618** for receiving program data, an output terminal at the output of slave latch **614** for providing read data, read data inversion circuit **608,** or data mismatch comparison logic **610.** SI register cell **700** is coupled to bitlines of the memory array and sense amplifier circuits which can be configured identically to the circuit of Figure 8.

Following is a description of the circuits that differ from SI register cell **600** of Figure 10. Instead of having an input for receiving program data, SI register cell **700** includes a reset circuit consisting of a transistor device **702** for coupling VDD to the input of master latch **612** in response to a reset signal RST. Reset signal RST can be a pulsed signal provided prior each programming operation to set a default program inhibit state for the inversion status cell. SI register cell **700** does not require read data inversion, as the inversion status bit is not provided externally to the memory device. The SAi_out line can be used as the RD_INV signal, or alternately, the output of slave latch **614** can provide the RD_INV signal. As previously described, the inversion status bit being permanently set to or programmed to a logic "1" indicates that the original program data stored in the data cell group **201** has been inverted due to the presence of a defective bit in the data cell group **201** or the presence of a defective inversion status cell.

Instead of data mismatch comparison logic **610,** defect detection logic **704** combines the global flag DEFECTi-1 from the last SI register cell **502** with an output of slave latch **614.** Accordingly, if either DEFECTi-1 or the output of slave latch **614** is at the logic "1" state, then PGM_INV is set to the active logic "1" state. In the present example, if slave latch **614** is at the "1" logic state, it means that the corresponding cell was previously determined to be defective, and pre-programmed to a specific logic state. The reclamation of a defective inversion status cell is the same as for a normal data storing cell. In the present embodiment, defect detection logic **704** includes an OR logic gate **706.** In the previously described embodiments, those skilled in the art should understand that alternate logic gates or circuits can be used to achieve the same desired result, since programmed and unprogrammed logic states may be reversed relative to those discussed for the present embodiments.

Now that example circuits have been described for implementing the redundancy scheme of the present embodiments, following are method embodiments describing sequences for operating the described memory device and circuits with redundancy.

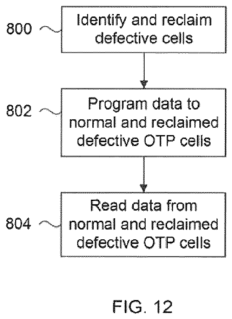

Figure 12 is a flow chart of a general method for operating a memory device having a redundancy scheme, according to the present embodiments. The method starts at **800** where defective cells are identified and reclaimed. This step includes identification of leaky cells at manufacturing and before end user programming, and by example, reclamation of leaky cells behaving as a programmed cell includes pre-programming them to a permanent logic "1". Redundancy has been implemented after step **800,** such that previously unusable cells are prepared for storing user data.

At step **802,** the end user which can also be the manufacturer, programs data to the memory array. Cell groups, such as cell group **200,** without any defective cells are programmed without inversion of the program data bits and the inversion status bit. Cell groupings with a defective cell, such as a pre-programmed "1" cell from step 800 may be inverted depending if the data bit position matches or mismatches the pre-programmed "1" of the corresponding defective cell.

At step **804** a read operation is executed to read data from the memory array. If the data is read from a cell group having a defective cell, then the read data is inverted into its original program data state for output. Otherwise, the read data is output without inversion. Therefore, even though program data may be stored in its inverted state, the resulting read data will always correspond to the original program data provided to the memory device.

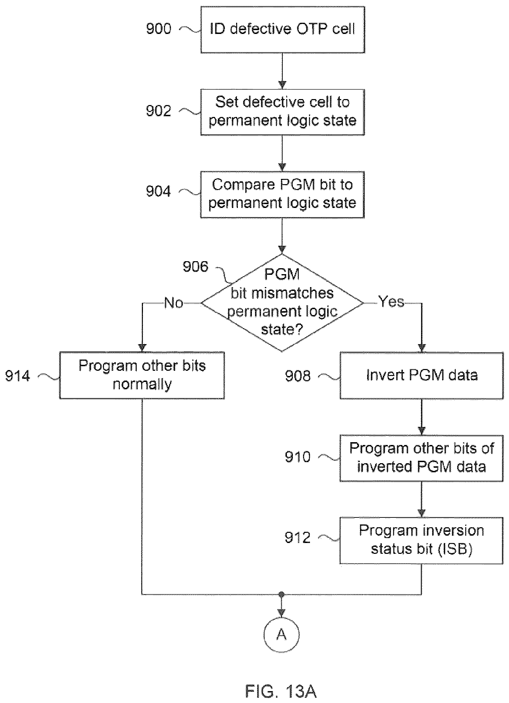

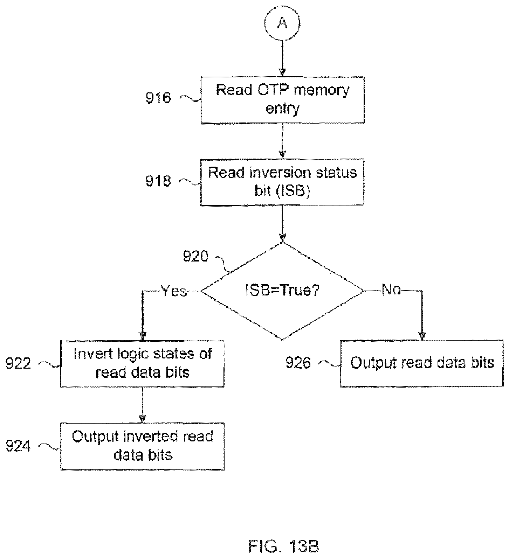

Figures 13A and 13B show a particular embodiment of the method shown in Figure 12. In the present method, it is assumed that the memory cells are OTP memory cells such as those described in the present application. Therefore reference is made to the circuit schematics of Figures 10 and 11, which are configured for these OTP memory cells. The method starts at step **900** where defective cells are identified using any suitable test technique. For example a read operation performed on all the unprogrammed cells can help determine if any are "leaky". Since such leaky cells tend to behave as programmed cells, the detected defective cells are programmed to store a permanent logic "1" at step **902.** This can be done by entering program data into the data register **306** of Figure 7, as would be done for a normal programming operation. However, this pre-programming of defective cells would typically be performed before shipping to end users for normal use and operation.

Steps **900** and **902** would be executed in step **800** of Figure 12. It is assumed that the memory device is ready for normal operation. Program data for a data cell group is provided to the SI register cells **502** of Figure 9 via the DL1_in to DLn_in lines, and is thus stored in the master latch **612.** At step **904,** a read operation is executed for the cells to which the program data is intended to be programmed into. This data is stored in the slave latch **614** of Figure 10, and each SI register cell **502** compares its slave latch data to its corresponding program data bit stored in master latch **612** using data mismatch comparison logic **610.**

At step **906,** assuming that one cell is defective (logic "1"), and the corresponding master latch **612** stores a logic "1", a mismatch is detected between the permanent logic state of the inversion status cell and the program data bit. In this case, the method proceeds to step **908** where all the program data bits are inverted. This is done by SI register cell **504** which asserts the PGM_INV signal. In response to PGM_INV, all SI register cells **502** of the data cell group clock their respective flip-flops **624.** At about the same time, SI register cell **504** also clocks its respective flip-flop **624** in response to PGM_INV. Signal EVAL can then be pulsed to flip the logic state of master latches **612.** Hence the program data of SI register cells **502,** and the reset logic "1" state stored by master latch **612** of SI register cell **504** is flipped to a logic "0". As part of step **908,** and after the EVAL signal has been pulsed, the PCH signal can be pulsed. This will re-invert the master latch **612** of the SI register cell **502** from the inverted logic "0" back to a logic "1" since coupling device **622** is presently turned on by the "1" logic state of the slave latch corresponding to the defective cell. Since the defective cell is already programmed, there is no need to reprogram it again. At steps **910** and **912,** the cells are programmed according to the data stored in the mater latches **612** of SI register cells **502** and **504.**

Returning to step **906,** if there is no mismatch between any of the data bits and the defective cell, or there is no defective cell in the cell group, then the data is programmed at step **914** without any program data inversion. Also, the inversion status bit remains unprogrammed. Steps **904, 908** to **912** or **914** are repeatedly executed for program operations. After programming, a read operation can be executed, which starts in Figure 13B.

At step **916,** it is assumed that the bitlines have been precharged and a wordline has been asserted for reading data from at least one cell group. The bitlines are sensed by bitline sense amplifier circuitry, and sensed bitline data is output. In the present embodiments, this sensed bitline data is provided to SI register cell **600** via the SAi_out line. Because the inversion status cell is connected to the same wordline as the cells of the present data cell group, the inversion status bit is read at substantially the same time at step **918.** In SI register cell **700,** the sensed inversion status bit is provided by the SAd_out line. If at step **920** the inversion status bit (ISB) is true, ie. a logic "1" for example, indicating that the data of the data cell group has been inverted relative to the original program data, then the method proceeds to step **922.** At step **922,** RD_INV is at the active logic level to control selector **632** of each SI register cell **600** to pass the output of inverter **630.** Now the slave latches **614** store the original received program data (inverted read data), which can then be output from the memory device via DLi_out at step **924.** Returning to step **920,** if the inversion status bit is false, ie. a logic "0" for example, then the selectors **632** of each SI register cell **600** couple SAi_out directly to slave latches **614.** The read data is then output via the DL_out lines in their uninverted form at step **926.**

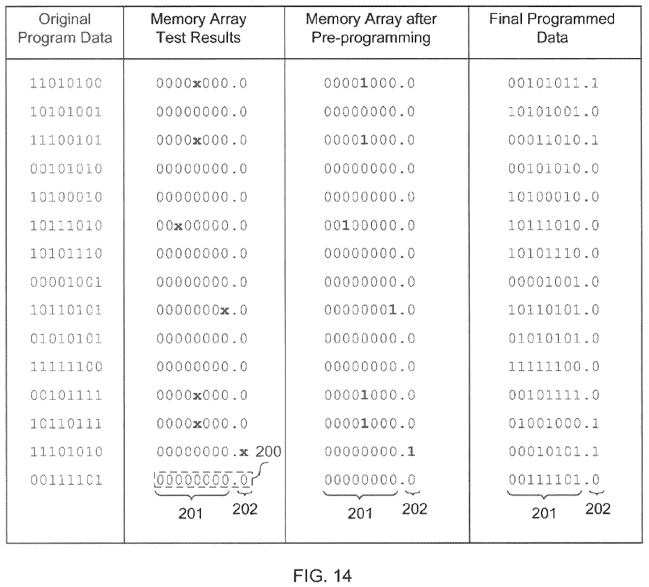

Figure 14 is a table showing example memory array cell groups **200,** program data to be stored in each data cell group **201,** and the final stored values in the respective cell groups **200** when the cell groups do not have a defective cell or have one defective cell. Starting from the left-most column in Figure 14, different program data are shown in each row. The second column shows rows of data cell groups **201** and their corresponding inversion status cell **202** after testing. Each row of program data is intended to be stored in a corresponding row of a data cell group. The testing shows that cells marked with an "x" are defective. It is noted that a status inversion cell **202** can be defective. In the present example, it is assumed that the test identifies leaky cells. The third column shows the status of the cell groups **200** of the same row after the defective leaky cells are programmed to a logic "1" state. The fourth column shows the final state of the programmed data of the row, stored in the cell group.

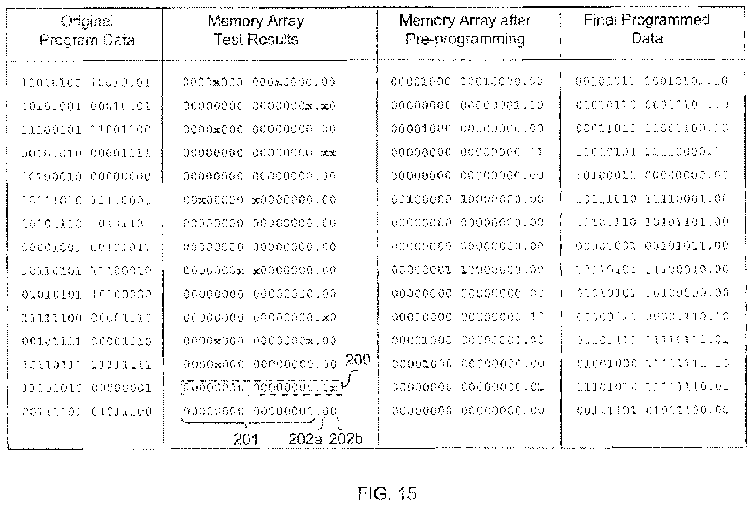

In Figure 14, one inversion status cell **202** is used for each n-bit data cell group **201.** Figure 15 is a table showing an alternate configuration where two inversion status cells can be used for respective segments of an n-bit data cell group of the cell group **200.** Figure 15 is a table similar to the one shown in Figure 14, except that now each row of program data consists of two segments, each being 8-bits in length. The corresponding data cell group **201** of the row in the adjacent column is visually divided into two 8-bit segments, and has two inversion status cells **202a** and **202b.** In the present example, inversion status cell **202a** is associated with the left-most 8-bits of the data cell group **201,** while inversion status cell **202b** is associated with the right-most 8-bits of the data cell group **201.** Accordingly, each segment can store inverted program data independently of the other.

The addition of further inversion status cells enables the correction of multiple cells. For example, in a row with 32 bits, each 8 bits of the 32 bits can be assigned one inversion status cell to correct one defective cell per 8 bits, thus correcting up to 4 defective cells per row. The distribution of the data segments in an entry can also be varied to optimize the method. For example the data segment can be contiguous, or distributed. For example one inversion status bit can be assigned for even data bits and another for odd data bits. The distribution of the data segments affects the distribution of the defective cells that can be corrected. For example for an NVM of 32 bits with 2 redundancy bits (one redundancy bit per 16 data bits). If the data segments are contiguous, one defective cell can be corrected in the first or second 16-bit segments. If the data segments are on even and odd rows, one defective cell in even or odd bits can be corrected.

The previously described embodiments show a redundancy technique to reclaim and reuse a defective, leaky cell. The presently described redundancy technique can be applied to reclaim and reuse a defective, weak cell. In contrast to the presently described leaky cell, a weak cell is one that is logically biased to a logic "0" as it has been found difficult to program. The principles of the present redundancy scheme applies to such cells when they have been detected in a cell group **200.** The following method can be a modified version of steps **906, 908, 910** and **912** of Figure 13A. It is first assumed that the programming operation of the memory device is reversible. Since multiple bits are to be programmed at the same time, it is possible that while one cell of the cell group **200** programs its logic "1" state, another cell cannot program its logic "1" state. Using logic circuits in the dual shift register of PAT 3672W-90, a program fail condition can be detected where the cell cannot be programmed after a number of preset programming iterations have been attempted. Because the auto-program inhibit circuit **604** of the SI register cell **600** can be used to flip the logic state stored in master latch **612** after the corresponding cell has been properly programmed, the only master latch **612** of the cell group **200** which has not successfully programmed after the preset programming iterations will have a logic "0" stored therein. Cells for which no programming was intended will have a logic "1" stored in the corresponding master latch **612.**

Since it is now known that a cell cannot be programmed (therefore weak), a program bit thus mismatches the permanent state of the failed cell, which corresponds to step **906** of Figure 13A. In modified step **908,** the programming of the cell group **200** is reversed to their default states and new program data being an inversion of the original program data is loaded into the SI register cells 600. At modified step **910** the inverted data is programmed and at modified step **912** the inversion status bit is programmed to indicate the presence of inverted program data in the corresponding data cell group. Therefore, the cell which failed to program a logic "1" now stores a logic "0".

Alternately, data having a bit position matching the biased logic state of the weak cell can be found for programming to the cell group **200** without any inversion after the failed programming condition is identified. In this process, the data stored in the master latches **612** are shifted to the slave latches **614,** and output on the DLi_out lines to identify the bit position where programming failed. Once the bit position of the failed programming operation is identified, any programming of the cell group **200** is reversed and suitable program data is loaded into the SI register cells **502** for programming. Accordingly, while leaky cells are identified during testing prior to use, weak cells are identified during an in-use programming operation.

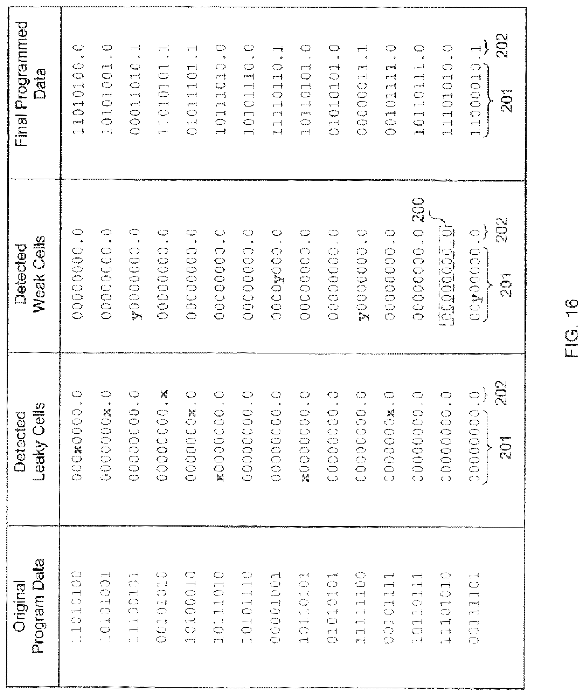

Figure 16 is a table illustrating the presently described redundancy technique for reclaiming both weak cells and leaky cells, according to a present embodiment. Starting from the left-most side of the table, the first column lists rows of different program data. The second column lists corresponding cell groups **200** having detected leaky cells marked with an "x". The third column lists the same cell groups **200** shown in rows of the second column, but having weak cells detected during a programming operation. The weak cells are marked with a "y". The fourth column shows the final programmed data in the cell groups **200,** where some program data is inverted if the data bit mismatches the preset permanent logic state of the corresponding cell in the cell group **200.** For those data cell groups **201** which store inverted program data, its corresponding inversion status cell **202** is programmed.

Looking at the program data bits from left to right, if the first bit position from the left is to be programmed to a logic "1", which corresponds to the bit position in the entry marked with a "y". As shown in right-most column, the entries are inverted when the data values starting with a "1" match the "y" position entry. Therefore when inverted, the "y" bit stores a logic "0", and the redundancy bit is programmed to the logic "1" state to indicate the inverted status of the stored data. It is noted that the same inversion status bit can be used for both types of errors.

Some embodiments disclosed herein utilize more than one inversion status cell. For example, some embodiments make use of two inversion status cells, while other embodiments make use of three inversion status cells. Other embodiments can make use of a greater number of inversion status cells. In embodiments that utilize more than one inversion status cell, the manner in which the inversion status cells are combined to determine whether or not an inversion occurs varies from embodiment to embodiment. For example, in some embodiments an inversion occurs if at least one of the inversion status cells has a value of logic "1". In other embodiments, an inversion does not occur unless all of the inversion status cells have a value of logic "1". In still other embodiment, an inversion does not occur unless an odd number of inversion status cells have a value of logic "1". These are non limiting examples and it will be understood that other methods can be used to combine the values of the inversion status bits to determine whether an inversion takes place or not.

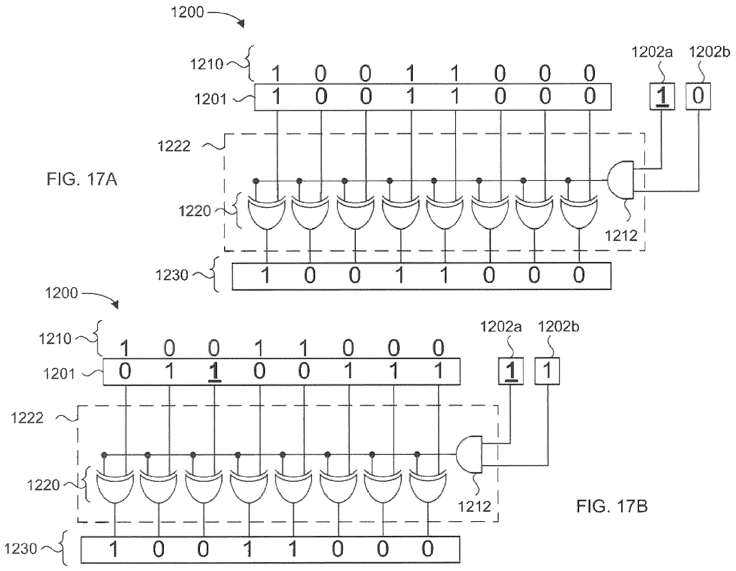

Reference is now made to Figure 17A which illustrates a schematic diagram of a circuit **1200,** which is an example of a circuit utilizing two inversion status bits, where both inversion status cells are programmed to a logic "1" in order for an inversion to occur. Circuit **1200** can be used to correct for one or more defective data cells, a defective leaky inversion status cell, or one or more defective data cells and a defective leaky inversion status cell. Circuit **1200** includes a data cell group **1201,** inversion status cells **1202a** and **1202b,** and an inversion processor **1222.** Inversion processor **1222** receives as inputs the logic states of inversion status cells **1202a** and **1202b.** Based on the values of inversion status cells **1202a** and **1202b,** inversion processor **1222** either outputs the logic values of data cells **1201** or the inverse of the logic values of data cells **1201.** In the embodiment illustrated in Figures 17A, when both of the inversion status cells **1202a** and **1202b** have a logic value of "1", the inversion processor **1222** outputs the inverted value of data cells group **1201.** On the other hand, when at least one of inversion status cells **1202a** and **1202b** has a logic value of "0", the inversion processor **1222** outputs the uninverted value of data cell group **1201.**

Inversion processor **1222** includes first logic circuitry including an AND gate **1212** and second logic circuitry including a plurality of XOR gates **1220.** The inputs of AND gate **1212** are coupled to the inversion status cells **1202a** and **1202b.** Each of the plurality of XOR gates **1220** has a first input coupled to the output of AND gate **1212** and a second input coupled to a data cell of group **1201.** The outputs **1230** of XOR gates **1220** represent the values of data cell group **1201** with or without inversion. In the embodiment of Figures 17A, the inversion status of the data cells is indicated by the combination of inversion status cells **1202a** and **1202b** according to the logic AND function (e.g. the output of AND gate **1212).** If the output of AND gate **1212,** also referred to as an inversion control signal, is a logic "1", then the outputs **1230** of XOR gates **1220** is the inverse of the values of data cell group **1201.** Conversely, if the output of AND gate **1212** is a logic "0", then the outputs **1230** of XOR gates **1220** is the same as the values of data cell group **1201.**

Figure 17A illustrates a situation in which inversion status cell **1202a** is defective, in that it is a leaky cell but can be permanently programed to logic "1". Figure 17A also illustrates a situation in which the data cells need not be inverted because they do not include defective cells. Accordingly, data cell group **1201** can be programed to match desired values **1210.** As will be understood by those of skill in the art, this discussion is also applicable to the situation in which the data cells include defective cells in positions such that the data cells can be made to match the desired values **1210** despite the defects (e.g. a leaky cell corresponding to a position in which the desired value is logic "1"). In the situation illustrated in 17A, inversion status cell **1202b** is set to logic "0", thereby causing the output of AND gate **1212** to be a logic "0", which in turn causes XOR gates **1220** to output the logic values of data cell group **1201** without inversion. Therefore, the outputs **1230** of XOR gates **1220** match the desired values **1210.** Accordingly, inversion status cell **1202b** serves as a backup in situations where inversion status cell **1202a** is a leaky cell because in such situations, as result of the AND function, the output of AND gate **1212** will be dictated by the value of the status cell **1202b.** As will be understood by of person of skill in the art, inversion status cells **1202a** and **1202b** are interchangeable. In other words, **1202a** can serve as a backup inversion status cell in situations where **1202b** is a leaky cell.

Figure 17B illustrates a circuit **1200** similar to Figure 17A, with a significant difference being that in Figure 17B data cell group **1201** includes a leaky cell. The circuit elements are similarly numbered in Figures 17A and 17B and their description will not be repeated here. Similar to Figure 17A, Figure 17B also illustrates a situation in which inversion status cell **1202a** is defective in that it is leaky. Such a cell can be set to a logic "1". As mentioned above, data cell group **1201** includes a cell that is a defective logic "1". The location of the defective cell of data cell group **1201** corresponds to a location where the desired value **1210** is a logic zero and therefore does not permit the data cell group **1201** to match the desired values **1210.** In such a situation, data cell group **1201** are programed to the inverse of desired values **1210.** In addition, inversion status cell **1202b** is set to logic "1", thereby causing the output of AND gate **1212** to be a logic "1", which in turn causes XOR gates **1220** to output the inverse of the logic values of data cell group **1201.** Therefore, the outputs **1230** of XOR gates **1220** match the desired values **1210.**

As mentioned above, it will be clear to a person of skill in the art that the use of two inversion status cells **(1202a** or **1202b)** along with AND gate **1212** in circuit **1200** provides an effective backup functionality when one of the inversion status cells (**1202a** or **1202b**) is a defective logic "1". However, circuit **1200** would not be quite as effective when one of the inversion status cells (**1202a** or **1202b**) is a defective logic "0" because, given the nature of the AND function, regardless of the value of the operational inversion status cell, the output of AND gate **1212** will be "0". In the case where one of the inversion status cells (**1202a** or **1202b**) is a defective logic "1", if the value the operational inversion status cell is set to "0" the output of AND gate **1212** will be "0" and the values of data cell group **1201** will not be inverted. However, if the value the operational inversion status cell is set to "1" the output of AND gate **1212** will be "1". Therefore, the values of data cell group **1201** will be inverted. Accordingly, when one of the inversion status cells is a defective logic "0", the output of AND gate **1212** will be "0" and an inversion of values of data cell group **1201** cannot occur, regardless of what value the operational inversion status cell is set to.

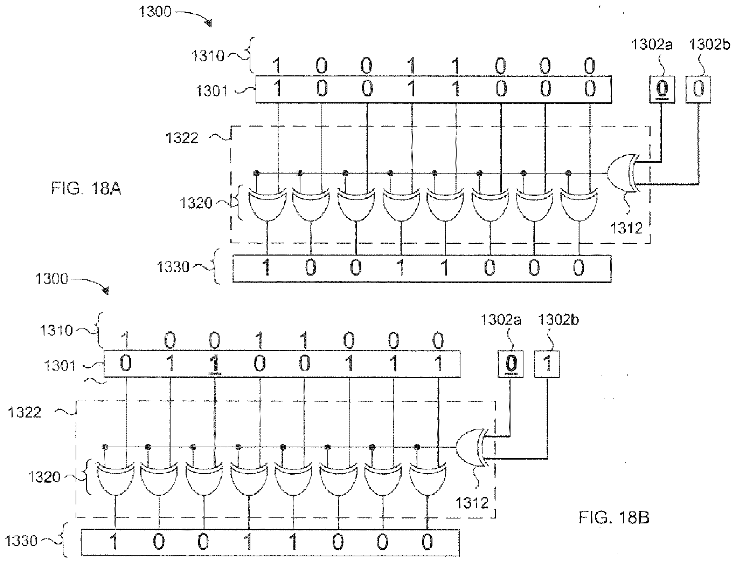

Reference is now made to Figure 18A which illustrates a schematic diagram of a circuit **1300,** which is similar to circuit **1200** and similarly functioning elements have been similarly numbered. As will be apparent to a person of skill in the art, one difference between circuit **1300** and **1200** is that circuit **1300** utilizes a XOR gate **1312** instead of an AND gate. Consequently, when circuit **1300** is used, regardless of whether one of the defective cells is a defective logic "1" or "0", the operational inversion status cell can be used to dictate whether the values of data cell group **1301** are inverted or not inverted by the inversion processor.

As mentioned above, inversion processor **1322** includes XOR gate **1312.** Consequently, when both of the inversion status cells **1302a** and **1302b** have the same logic value (e.g. both are "1" or both are "0"), the output of XOR gate **1312** is a logic "1" and the inversion processor **1322** outputs the uninverted value of data cell group **1301.** On the other hand, when inversion status cells **1302a** and **1302b** have different logic values (i.e. one of inversion status cells **1302a** and **1302b** is a "1" while the other is a "0"), the output of XOR gate **1312** is a logic "0" and the inversion processor **1322** outputs the inverted value of data cell group **1301.**

When either there are no defective data cells or the defective data cells have values matching the desired values, then no inversion is required. In such a situation, the values of **1302a** and **1302b** can be set to be either both be "1" or both be "0". Such a situation is illustrated in Figure 18A.

Conversely, as discussed below in relation to Figure 18B, an inversion may be used when there is a mismatch between a desired value **1310** and a defective cell value in data cell group **1301.** For example, the desired value may be a logic "0" while the data cell comprises a leaky cell at the corresponding location of the data cell group **1301.** In such a situation, one of inversion status cell **1302a** and **1302b** can be set to a logic value of "1" while the other can be set to a logic value of "0".

Figure 18A illustrates a situation in which inversion status cell **1302a** is defective in that it is a weak cell and cannot be reliably programed to a logic "1". However, the cell can be set to logic "0". Figure 18A also illustrates a situation in which the data cells need not be inverted because they do not include defective cells. Accordingly, data cell group **1301** can be programed to match desired values **1310.** As will be understood by those of skill in the art, this discussion is also applicable to the situation in which the data cells include defective cells in positions such that the data cells can be made to match the desired values **1310** despite the defects. In the situation illustrated in 18A, inversion status cell **1302b** is set to logic "0", thereby causing the output of XOR gate 1312 to be a logic "0", which in turn causes XOR gates **1320** to output the logic values of data cell group **1301** without inversion. Therefore, the outputs **1330** of XOR gates **1320** match the desired values **1310.** If on the other hand inversion status cell **1302a** were a leaky cell, then inversion status cell **1302a** could be programed to a logic "1" and inversion status cell **1302b** could be programed to a logic "1" which would also result in the outputs **1330** of XOR gates **1320** matching the desired values **1310.** Accordingly, inversion status cell **1302b** serves as a backup in situations where **1302a** is a defective cell (either a leaky cell or a hard to program cell). As a result of the OR function, regardless of the value of inversion status cell **1302a,** the output of XOR gate **1312** can be controlled to be either a logic "1" or a logic "0" by programming inversion status cell **1302b** to the appropriate value. As will be understood by a person of skill in the art, **1302a** and **1302b** are interchangeable. In other words, the above description is equally applicable to situations where inversion status cell **1302b** is a defective cell and inversion status cell **1302a** serves as a backup.

Figure 18B illustrates a circuit **1300** similar to Figure 18A, with a difference being that in Figure 18B data cell group **1301** includes a leaky cell. The circuit elements are similarly numbered in Figures 18A and 18B and their description will not be repeated here. Similar to Figure 18A, Figure 18B also illustrates a situation in which inversion status cell **1302a** is defective in that it is a weak cell and cannot be reliably programed to a logic "1". However, the cell can be set to logic "0". Data cell group **1301** includes a cell that is a defective logic "1" (leaky) in a location where the desired value **1310** is a logic zero and therefore does not permit the data cell group **1301** to match the desired values **1310.** In such a situation, the values data cell group **1301** are programed to the inverse of desired values **1310.** In addition, inversion status cell **1302b** is set to logic "1", thereby causing the output of XOR gate **1312** to be a logic "1", which in turn causes XOR gates **1320** to output the inverse of the logic values of data cell group **1301.** Therefore, the outputs **1330** of XOR gates **1320** match the desired values **1310.** If on the other hand inversion status cell **1302a** were a leaky cell, then inversion status cell **1302a** could be programed to a logic "1" and inversion status cell **1302b** could be programed to a logic "0" which would also result in the outputs **1330** of XOR gates **1320** matching the desired values **1310.** Again, **1302a** and **1302b** are interchangeable and therefore, the above description is equally applicable to the situation where **1302b** is defective and **1302a** is operational.

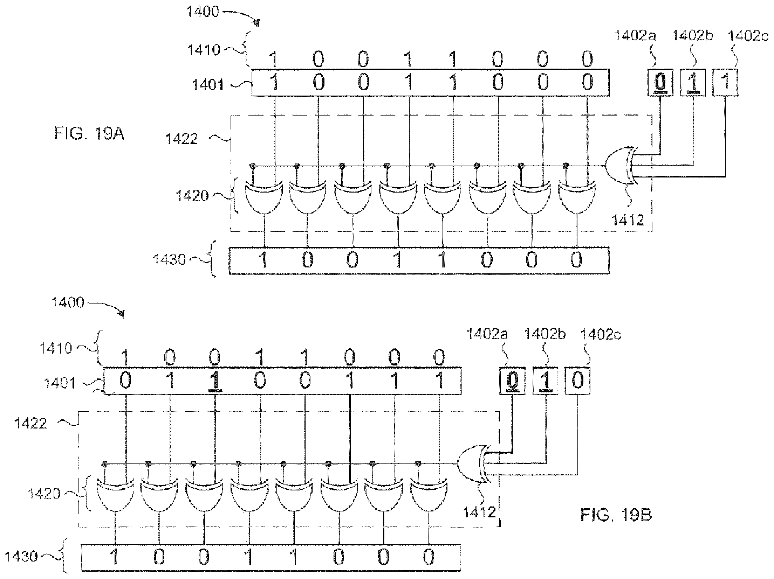

Reference is now made to Figure 19A which illustrates a schematic diagram of a circuit **1400,** which is similar to circuit **1300** and similarly functioning elements have been similarly numbered. As will be apparent to a person of skill in the art, one difference between circuits **1300** and **1400** is that circuit **1400** utilizes three inversion status cells in contrast to the two utilized in circuit 1300.

Circuit **1400** that can be used to correct for the following situations: (i) one or more defective data cells, (ii) one or more defective inversion status cells, (iii) or one or more defective data cells and one or more defective inversion status cells. For example, even when two of the three inversion status cells are defective, the lone operational inversion status cell can be used to control whether the values of data cell group **1401** are inverted at output **1430.**

Circuit **1400** includes a data cell group **1401,** inversion status cells **1402a, 1402b,** and **1202c,** and an inversion processor **1422.** Inversion processor **1422** receives as inputs the logic states of inversion status cells **1402a, 1402b,** and **1402c,** based on the values of which, inversion processor **1422** either outputs the logic values of data cells **1401** or the inverse of the logic values of data cells **1401.** In the embodiment illustrated in Figure 19A, inversion processor makes use of a three input XOR gate **1412.** XOR gate **1412** outputs a logic '0' when the three inputs comprise an even number of logic '1's. As used herein, the expression "an even number of logic '1's" includes no logic '1's (i.e. when all inputs are logic '0'). XOR gate **1412** outputs a logic '1' when the three inputs comprise an odd number of '1's. Accordingly, when an odd number of inversion status cells **1402a, 1402b,** and **1402c** have a logic value of "1", the inversion processor **1422** outputs the inverted value of data cell group **1401.** On the other hand, when an even number of inversion status cells **1402a, 1402b,** and **1402c** have a logic value of "1" (or when all of inversion status cells **1402a, 1402b,** and **1402c** have a logic value of "0"), the inversion processor **1222** outputs the non-inverted value of data cell group **1401.**

Figure 19A illustrates a situation in which inversion status cell **1402a** is defective in that it is a weak cell and cannot be reliably programed to a logic "1". However, the cell can be set to logic "0". In addition, inversion status cell **1402b** is defective in that it is a leaky cell but can be permanently programed to logic "1". Figure 19A also illustrates a situation in which the data cells need not be inverted because they do not include defective cells. Accordingly, data cell group **1401** can be programed to match desired values **1410.** As will be understood by those of skill in the art, this discussion is also applicable to the situation in which the data cells include defective cells in positions such that the data cells can be made to match the desired values **1410** despite the defect. In the situation illustrated in 19A, inversion status cell **1402c** is set to logic "1", thereby causing the output of XOR gate **1412** to be a logic "0", which in turn causes XOR gates **1420** to output the logic values of data cell group **1401** without inversion. Therefore, the outputs **1430** of XOR gates **1420** match the desired values **1410.** If on the other hand inversion status cells **1402a** and **1402b** were of the same value, then inversion status cell **1402c** could be programed to a logic "0" which would result in the outputs **1430** of XOR gates **1420** matching the desired values **1410.**

Figure 19B illustrates a circuit **1400** similar to Figure 19A, with a difference being that in Figure 19B data cell group **1401** includes a leaky cell. The circuit elements are similarly numbered in Figures 19A and 19B and their description will not be repeated here. As with Figure 19A, Figure 19B also illustrates a situation in which inversion status cell **1402a** is defective in that it is a weak cell and cannot be reliably programed to a logic "1". However, the cell can be set to logic "0". In addition, inversion status cell **1402b** is defective in that it is a leaky cell but can be permanently programed to logic "1". Data cell group **1401** includes a cell that is a defective logic "1" in a location where the desired value **1410** is a logic zero and therefore does not permit the data cell group **1401** to match the desired values **1410.** In such a situation, data cell group **1401** are programed to the inverse of desired values **1410.** In addition, inversion status cell **1402c** is set to logic "0", thereby causing the output of XOR gate **1412** to be a logic "1", which in turn causes XOR gates **1420** to output the inverse of the logic values of data cell group **1401.** Therefore, the outputs **1430** of XOR gates **1420** match the desired values **1410.** If on the other hand inversion status cells **1402a** and **1402b** were of the same value (either both '0' or both '1'), then inversion status cell **1402c** could be programed to a logic "1" which would also result in the outputs **1430** of XOR gates **1420** matching the desired values **1410.**

In the above description of Figures 19A and 19B, each of inversion status cells **1402a, 1402b,** and **1402c** is interchangeable. Accordingly, the above description is applicable regardless of which of the inversion status cells are defective and which is operational. Provided that at least one inversion status cell is operational, circuit **1400** can be operated to either invert or not invert the values stored in data cell group **1401.**

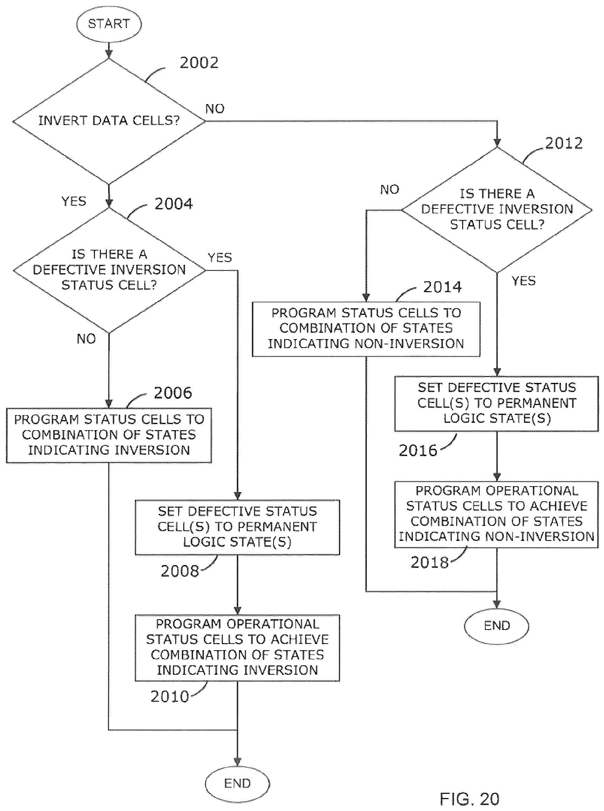

Figure 20 is a flowchart illustrating an example redundancy method for circuits utilizing a plurality of inversion status cells, such as, for example, circuits **1200, 1300,** and **1400** of Figures 17A to 19B. The method may contain additional or fewer processes than shown and/or described, and may be performed in a different order.

At **2002,** a determination is made as to whether or not to invert data cells. This determination can be made in any suitable manner such as, for example, as described above in relation to Figures 6A, 6B, and 6C. If the data cells are to be inverted due to one or more defective cells, then the method proceeds to **2004.** If the data cells are not to be inverted, then the method proceeds to **2012.**

At **2004,** a determination is made as to whether there is a defective inversion status cell. If there are no defective inversion status cells, then **2006** is executed next. On the other hand, if there is at least one defective inversion status cell, then **2008** is executed next.

At **2006,** the inversion status cells are programed to a combination of states that indicates inversion of the data cells. For example, in the case of circuit **1300,** one of the inversion status cells would be programed to a logic '1' while the other inversion status cell would be programed to a logic '0'. In the case of circuit **1400,** the inversion status cells would be programed such that there is an odd number of inversion status cells programed to logic '1'.

On the other hand, if there is at least one defective inversion status cell, then at **2008,** each defective inversion status cell is set to a permanent logic state depending on the defect affecting the particular cell.

At **2010,** the remaining operational inversion status cells are programed to achieve a combination of programed states indicating inversion. In various embodiments, the number of inversion status cells referred to in the previous sentence includes the defective inversion status cell(s). For example, in the case of circuit **1400** of Figures 19A and 19B, the operational inversion status cells would be programed such that there are an odd number inversion status cells programed to logic '1', including any defective cells. Accordingly, in the example of Figure 19B, cell **1402c** is the only remaining operational inversion status cell and it is programed to a logic '0' such that the combination of logic states of inversion status cells **1402a, 1402b,** and **1402c,** indicates an inversion.

Referring now to **2012** where a determination is made as to whether there is a defective inversion status cell. If there are no defective inversion status cells, then **2014** is executed next. On the other hand, if there is at least one defective inversion status cell then **2016** is executed next.

At **2014,** the inversion status cells are programed to a combination of states that indicates non-inversion of the data cells. For example, in the case of circuit **1300,** both of the inversion status cells would be programed to the same logic value (i.e. both programed to a logic '1' or both programed to a logic '0'). In the case of circuit **1400,** the inversion status cells would be programed such that there is an even number of inversion status cells programed to logic '1'.

On the other hand, if there is at least one defective inversion status cell, then at **2016,** each defective inversion status cell is set to a permanent logic state depending on the defect affecting the particular cell.

At **2018,** the remaining operational inversion status cells are programed to achieve a combination of programed states indicating non-inversion. In various embodiments, the number of inversion status cells referred to in the previous sentence includes the defective inversion status cell(s). For example, in the case of circuit **1400,** the operational inversion status cells would be programed such that there are an even number inversion status cells programed to logic '1', including any defective cells. Accordingly, in the example of Figure 19A, cell **1402c** is the only remaining operational inversion status cell and it is programed to a logic '1' such that the combination of logic states of inversion status cells **1402a, 1402b,** and **1402c,** indicates non-inversion.

Although the present description describes and illustrates circuits having 1, 2, or 3 inversion status cells, a larger number of status cells can be used. More specifically, an arbitrarily large number of status cells could be used. As an example, the circuit **1400** could be adapted to have 10 inversion status cells. This would allow up to 9 inversion status cells to be defective while still allowing the remaining operational status cell(s) to control whether or not the values of data cells group **1401** at the output **1430.** However, there is a trade-off between the additional reliability added through the use of a greater number of inversion status cells and the "cost" of having these additional inversion status cells as well as the circuitry used to process the additional inputs (e.g. the greater area circuit area required and additional power requirements).

The embodiments of the present invention can be used with any programmable non-volatile memory, where defective cells exhibit biased logic states. The previously described embodiments of the self-inverting data register **310** is one means for performing defective cell detection, program data inversion and read data inversion. Alternate techniques and circuits can be developed for obtaining the same desired result.

In the preceding description, for purposes of explanation, numerous details are set forth in order to provide a thorough understanding of the embodiments of the invention. However, it will be apparent to one skilled in the art that these specific details are not required in order to practice the invention. In other instances, well-known electrical structures and circuits are shown in block diagram form in order not to obscure the invention. For example, specific details are not provided as to whether the embodiments of the invention described herein are implemented as a software routine, hardware circuit, firmware, or a combination thereof.

The above-described embodiments of the invention are intended to be examples only. Alterations, modifications and variations can be effected to the particular embodiments by those of skill in the art within the scope of the invention, which is defined solely by the claims appended hereto.

## Claims

1. A non-volatile memory comprising:
n data cells (1201; 1301; 1401) for storing an n-bit entry (1210; 1310; 1410), where a defective data cell of the n data cells is settable to a permanent logic state;
at least two inversion status cells (1202a, 1202b; 1302a, 1302b; 1402a, 1402b, 1402c), each programmable between two states, where a first combination of logic states of the at least two inversion status cells together indicates that an inversion operation is to be performed on all the n data cells (1201; 1301; 1401) and a second combination of logic states of the at least two inversion status cells together indicates that an inversion operation is not to be performed on all the n data cells, a defective cell of the at least two inversion status cells being programmable to one of two permanent logic states, wherein the defective inversion status cell is a weak cell or leaky cell, and an operational cell of the at least two inversion status cells programmable to one of two logic states to achieve either the first or second combination of logic states; and
an inversion processor (1222; 1322; 1422) coupled to the n data cells (1201; 1301; 1401) and the at least two inversion status cells (1202a, 1202b; 1302a; 1302b; 1402a, 1402b, 1402c), the inversion processor (1222; 1322; 1422) being configured to output either the n-bit entry or an inverse of the n-bit entry based on the first or the second combination of logic states of the at least two inversion status cells (1202a, 1202b; 1302a, 1302b; 1402a, 1402b, 1402c), the inversion processor (1222; 1322; 1422) including:
first logic circuitry (1212; 1312; 1412) configured to receive logic states of the at least two inversion status cells and provide an inversion control signal, and
second logic circuitry (1220; 1320; 1420) configured to receive logic states of the n-bit entry, and to invert the n-bit entry in response to the inversion control signal.

2. The non-volatile memory of claim 1, wherein the first logic circuitry includes AND logic.

3. The non-volatile memory of claim 1, wherein the first logic circuitry includes Exclusive OR, XOR, logic.

4. The non-volatile memory of claim 1, wherein the at least two inversion status cells comprise three inversion status cells.

5. The non-volatile memory of claim 1, wherein the second logic circuitry includes XOR logic corresponding to each entry of the n-bit entry.

6. The non-volatile memory of claim 5, wherein the XOR logic for each entry of the n-bit entry includes
a first input for receiving a logic state corresponding to one bit of the n-bit entry,
a second input for receiving the inversion control signal, and
an output for providing an inversion of the logic state received at the first input in response to the inversion control signal.

7. A redundancy method for a non-volatile memory comprising a plurality of groupings of n memory cells (1201; 1301; 1401), wherein each of the groupings includes at least two inversion status cells (1202a, 1202b; 1302a, 1302b; 1402a, 1402b, 1402c), comprising, for each grouping:
a) determining whether to invert logic states of program data stored in the grouping or maintain the logic states of the program data stored in the grouping;
b) detecting a defect in at least one of the inversion status cells (1202a, 1202b; 1302a, 1302b; 1402a, 1402b, 1402c), wherein the at least one defective inversion status cell is a weak cell or leaky cell, the inversion status cells for storing a first combination of logic states of the at least two inversion status cells together indicating an inversion determination and a second combination of logic states of the at least two inversion status cells together indicating a non-inversion determination;
c) programming at least one defective inversion status cell (1202a, 1202b; 1302a, 1302b; 1402a, 1402b, 1402c) to one of two permanent logic states;
d) setting at least one non-defective inversion status cell of the plurality of inversion status cells (1202a, 1202b; 1302a, 1302b; 1402a, 1402b, 1402c) to a specific logic state, such that a logical combination of the specific logic state with the at least one defective inversion status cell permanent logic state provides an indication matching the determination to invert or maintain the logic states of the program data stored in all of the n memory cells of the grouping.

8. The redundancy method of claim 7, further including
programming the memory cells (1201; 1301; 1401) with one of the logic states of the program data and the inverted logic states of the program data, and programming the inversion status cells (1202a, 1202b; 1302a, 1302b; 1402a, 1402b, 1402c) with the logical combination of specific and permanent logic states.

9. The redundancy method of claim 8, further including
reading the memory cells (1201; 1301; 1401),
reading the inversion status cells (1202a, 1202b; 1302a, 1302b; 1402a, 1402b, 1402c), and
inverting read data of the memory cells (1201; 1301; 1401) when the logical combination of specific and permanent logic states indicates the read data was programmed in an inverted state.

10. The redundancy method of claim 9, wherein inverting includes
executing a logical operation on the logical combination of specific and permanent logic states to provide an inversion control signal, and
executing an inversion operation on the read data in response to the inversion control signal.

11. The redundancy method of claim 7, wherein the inversion status cells (1202a, 1202b; 1302a, 1302b; 1402a, 1402b, 1402c) includes two inversion status cells.

12. The redundancy method of claim 7, wherein the inversion status cells (1202a, 1202b; 1302a, 1302b; 1402a, 1402b, 1402c) includes three inversion status cells.

13. The redundancy method of claim 7, wherein the logical combination is an AND operation.

14. The redundancy method of claim 7, wherein the logical combination is an Exclusive Or, XOR, operation.

## Patentansprüche

1. Nicht-flüchtiger Speicher, umfassend:
n Datenzellen (1201; 1301; 1401) zum Speichern eines n-Bit-Eintrags (1210; 1310; 1410), wobei eine defekte Datenzelle der n Datenzellen in einen permanenten logischen Zustand versetzbar ist;
mindestens zwei Inversions-Status-Zellen (1202a, 1202b; 1302a, 1302b; 1402a, 1402b, 1402c), jeweils programmierbar zwischen zwei Zuständen, wobei eine erste Kombination logischer Zustände der mindestens zwei Inversions-Status-Zellen zusammen anzeigt, dass eine Inversions-Operation an allen n Datenzellen (1201; 1301; 1401) durchzuführen ist und eine zweite Kombination logischer Zustände der mindestens zwei Inversions-Status-Zellen zusammen anzeigt, dass keine Inversions-Operation an allen n Datenzellen durchzuführen ist, eine defekte Zelle der mindestens zwei Inversions-Status-Zellen, programmierbar auf einen von zwei permanenten logischen Zuständen, wobei die defekte Inversions-Status-Zelle eine schwache Zelle oder eine leckende Zelle ist, und eine funktionsfähige Zelle der mindestens zwei Inversions-Status-Zellen auf einen von zwei logischen Zuständen programmierbar ist, um entweder die erste oder die zweite Kombination logischer Zustände zu erreichen; und
einen Inversions-Prozessor (1222; 1322; 1422), gekoppelt mit den n Datenzellen (1201; 1301; 1401) und den mindestens zwei Inversions-Status-Zellen (1202a, 1202b; 1302a, 1302b; 1402a, 1402b, 1402c), der Inversions-Prozessor (1222; 1322; 1422) konfiguriert, um entweder den n-Bit Eintrag oder einen Kehrwert des n-Bit Eintrags auf Basis der ersten oder der zweiten Kombination logischer Zustände der mindestens zwei Inversions-Status-Zellen (1202a, 1202b; 1302a, 1302b; 1402a, 1402b, 1402c) auszugeben, der Inversions-Prozessor (1222; 1322; 1422) einschließend:
erste Logikschaltung (1212; 1312; 1412), konfiguriert, um logische Zustände der mindestens zwei Inversions-Status-Zellen zu empfangen und ein Inversions-Steuerungs-Signal bereitzustellen, und
zweite Logikschaltung (1220; 1320; 1420), konfiguriert, um logische Zustände des n-Bit-Eintrags zu empfangen und den n-Bit Eintrag zu invertieren in Reaktion auf das Inversions-Steuerungs-Signal.

2. Nicht-flüchtiger Speicher gemäß Anspruch 1, wobei die erste Logikschaltung AND Logik einschließt.

3. Nicht-flüchtiger Speicher gemäß Anspruch 1, wobei die erste Logikschaltung Exklusiv OR, XOR, Logik einschließt.

4. Nicht-flüchtiger Speicher gemäß Anspruch 1, wobei die mindestens zwei Inversions-Status-Zellen drei Inversions-Status-Zellen umfassen.

5. Nicht-flüchtiger Speicher gemäß Anspruch 1, wobei die zweite Logikschaltung XOR Logik einschließt, entsprechend jedem Eintrag des n-Bit-Eintrags.

6. Nicht-flüchtiger Speicher gemäß Anspruch 5, wobei die XOR Logik für jeden Eintrag des n-Bit-Eintrags
einen ersten Eingang zum Empfangen eines logischen Zustands, entsprechend einem Bit des n-Bit-Eintrags,
einen zweiten Eingang zum Empfangen des Inversions-Steuerungs-Signals, und
einen Ausgang zum Bereitstellen einer Inversion des logischen Zustands, empfangen an dem ersten Eingang in Reaktion auf das Inversions-Steuerungs-Signal einschließt.

7. Redundanz-Verfahren für einen nicht-flüchtigen Speicher, umfassend eine Vielzahl von Gruppierungen von n Speicherzellen (1201; 1301; 1401), wobei jede der Gruppierungen mindestens zwei Inversions-Status-Zellen (1202a, 1202b; 1302a, 1302b; 1402a, 1402b, 1402c) einschließt, umfassend für jede Gruppierung:
a) Bestimmen, ob logische Zustände von Programmdaten, gespeichert in der Gruppierung, zu invertieren sind oder ob die logischen Zustände der Programmdaten, gespeichert in der Gruppierung beizubehalten sind;
b) Erfassen eines Defekts in mindestens einer der Inversions-Status-Zellen (1202a, 1202b; 1302a, 1302b; 1402a, 1402b, 1402c), wobei die mindestens eine defekte Inversions-Status-Zelle eine schwache Zelle oder leckende Zelle ist, die Inversions-Status-Zellen zum Speichern einer ersten Kombination logischer Zustände der mindestens zwei Inversions-Status-Zellen zusammen anzeigend eine Inversionsentscheidung und eine zweite Kombination logischer Zustände der mindestens zwei Inversions-Status-Zellen zusammen anzeigend eine Nicht-Inversionsentscheidung;
c) Programmieren mindestens einer defekten Inversions-Status-Zelle (1202a, 1202b; 1302a, 1302b; 1402a, 1402b, 1402c) auf einen von zwei permanenten logischen Zuständen;
d) Versetzen mindestens einer nicht-defekten Inversions-Status-Zelle der Vielzahl von Inversions-Status-Zellen (1202a, 1202b; 1302a, 1302b; 1402a, 1402b, 1402c) auf einen spezifischen logischen Zustand, sodass eine logische Kombination des spezifischen logischen Zustands mit dem mindestens einen deffekten Inversions-Status-Zellen permanenten logischen Zustand eine Anzeige bereitstellt, übereinstimmend mit der Entscheidung die logischen Zustände der Programmdaten, gespeichert in allen n Speicherzellen der Gruppierung, zu invertieren oder beizubehalten.

8. Redundanz-Verfahren gemäß Anspruch 7, ferner einschließend
Programmieren der Speicherzellen (1201; 1301; 1401) mit einem der logischen Zustände der Programmdaten und den invertierten logischen Zuständen der Programmdaten, und Programmieren der Inversions-Status-Zellen (1202a, 1202b; 1302a, 1302b; 1402a, 1402b, 1402c) mit der logischen Kombination spezifischer und permanenter logischer Zustände.

9. Redundanz-Verfahren gemäß Anspruch 8, ferner einschließend
Lesen der Speicherzellen (1201; 1301; 1401),
Lesen der Inversions-Status-Zellen (1202a, 1202b; 1302a, 1302b; 1402a, 1402b, 1402c), und
Invertieren gelesener Daten der Speicherzellen (1201; 1301; 1401), wenn die logische Kombination spezifischer und permanenter logischer Zustände anzeigt, dass die gelesenen Daten in einem invertierten Zustand programmiert waren.

10. Redundanz-Verfahren gemäß Anspruch 9, wobei Invertieren
Ausführen einer logischen Operation an der logischen Kombination spezifischer und permanenter logischer Zustände, um ein Inversions-Steuerungs-Signal bereitzustellen, einschließt und
Ausführen einer Inversions-Operation an den gelesenen Daten in Reaktion auf das Inversions-Steuerungs-Signal.

11. Redundanz-Verfahren gemäß Anspruch 7, wobei die Inversions-Status-Zellen (1202a, 1202b; 1302a, 1302b; 1402a, 1402b, 1402c) zwei Inversions-Status-Zellen einschließt.

12. Redundanz-Verfahren gemäß Anspruch 7, wobei die Inversions-Status-Zellen (1202a, 1202b; 1302a, 1302b; 1402a, 1402b, 1402c) drei Inversions-Status-Zellen einschließt.

13. Redundanz-Verfahren gemäß Anspruch 7, wobei die logische Kombination eine AND Operation ist.

14. Redundanz-Verfahren gemäß Anspruch 7, wobei die logische Kombination eine Exklusiv Or, XOR, Operation ist.

## Revendications

1. Mémoire non volatile comprenant :
« n » cellules de données (1201 ; 1301 ; 1401) destinées à stocker une entrée à « n » bits (1210 ; 1310 ; 1410), où une cellule de données défectueuse des « n » cellules de données peut être définie sur un état logique permanent ;
au moins deux cellules d'état d'inversion (1202a, 1202b ; 1302a, 1302b ; 1402a, 1402b, 1402c), lesquelles sont chacune programmables entre deux états, où une première combinaison d'états logiques desdites au moins deux cellules d'état d'inversion indique conjointement qu'une opération d'inversion doit être mise en oeuvre sur la totalité des « n » cellules de données (1201 ; 1301 ; 1401), et une seconde combinaison d'états logiques desdites au moins deux cellules d'état d'inversion indique conjointement qu'une opération d'inversion ne doit pas être mise en oeuvre sur la totalité des « n » cellules de données, une cellule défectueuse desdites au moins deux cellules d'état d'inversion étant programmable sur l'un parmi deux états logiques permanents, dans lequel la cellule d'état d'inversion défectueuse est une cellule faible ou une cellule partiellement fonctionnelle, et une cellule opérationnelle desdites au moins deux cellules d'état d'inversion étant programmable sur l'un parmi deux états logiques pour obtenir soit la première combinaison d'états logiques, soit la seconde combinaison d'états logiques ; et
un processeur d'inversion (1222 ; 1322 ; 1422) couplé auxdites « n » cellules de données (1201 ; 1301 ; 1401) et auxdites au moins deux cellules d'état d'inversion (1202a, 1202b ; 1302a, 1302b ; 1402a, 1402b, 1402c), le processeur d'inversion (1222 ; 1322 ; 1422) étant configuré de manière à fournir en sortie soit l'entrée à « « n » » bits, soit un inverse de l'entrée à « « n » » bits, sur la base de la première combinaison d'états logiques ou de la seconde combinaison d'états logiques desdites au moins deux cellules d'état d'inversion (1202a, 1202b ; 1302a, 1302b ; 1402a, 1402b, 1402c), le processeur d'inversion (1222 ; 1322 ; 1422) incluant :
un premier montage de circuits logiques (1212 ; 1312 ; 1412) configuré de manière à recevoir des états logiques desdites au moins deux cellules d'état d'inversion et à fournir un signal de commande d'inversion ; et
un second montage de circuits logiques (1220 ; 1320 ; 1420) configuré de manière à recevoir des états logiques de l'entrée à « n » bits, et à inverser l'entrée à « n » bits en réponse au signal de commande d'inversion.

2. Mémoire non volatile selon la revendication 1, dans laquelle le premier montage de circuits logiques inclut une logique ET.

3. Mémoire non volatile selon la revendication 1, dans laquelle le premier montage de circuits logiques inclut une logique « OU exclusif », OUX.

4. Mémoire non volatile selon la revendication 1, dans laquelle lesdites au moins deux cellules d'état d'inversion comprennent trois cellules d'état d'inversion.

5. Mémoire non volatile selon la revendication 1, dans laquelle le second montage de circuits logiques comprend une logique OUX correspondant à chaque entrée de l'entrée à « n » bits.

6. Mémoire non volatile selon la revendication 5, dans laquelle la logique OUX pour chaque entrée de l'entrée à « n » bits inclut :
une première entrée destinée à recevoir un état logique correspondant à un bit de l'entrée à « n » bits ;
une seconde entrée destinée à recevoir le signal de commande d'inversion ; et
une sortie destinée à fournir une inversion de l'état logique reçu au niveau de la première entrée en réponse au signal de commande d'inversion.

7. Procédé de redondance pour une mémoire non volatile comprenant une pluralité de groupements de « n » cellules de mémoire (1201 ; 1301 ; 1401), dans lequel chacun des groupements inclut au moins deux cellules d'état d'inversion (1202a, 1202b ; 1302a, 1302b ; 1402a, 1402b, 1402c), comprenant, pour chaque groupement, les étapes ci-dessous consistant à :
a) déterminer s'il convient d'inverser des états logiques de données de programme stockées dans le groupement ou de maintenir les états logiques des données de programme stockées dans le groupement ;
b) détecter un défaut dans au moins l'une des cellules d'état d'inversion (1202a, 1202b ; 1302a, 1302b ; 1402a, 1402b, 1402c), dans lequel ladite au moins une cellule d'état d'inversion défectueuse est une cellule faible ou une cellule partiellement fonctionnelle, les cellules d'état d'inversion étant destinées à stocker une première combinaison d'états logiques desdites au moins deux cellules d'état d'inversion indiquant conjointement une détermination d'inversion, et une seconde combinaison d'états logiques desdites au moins deux cellules d'état d'inversion indiquant conjointement une détermination de non-inversion ;
c) programmer au moins une cellule d'état d'inversion défectueuse (1202a, 1202b ; 1302a, 1302b ; 1402a, 1402b, 1402c) sur l'un parmi deux états logiques permanents ;
d) définir au moins une cellule d'état d'inversion non défectueuse de la pluralité de cellules d'état d'inversion (1202a, 1202b ; 1302a, 1302b ; 1402a, 1402b, 1402c) sur un état logique spécifique, de sorte qu'une combinaison logique de l'état logique spécifique avec ledit au moins un état logique permanent de la cellule d'état d'inversion défectueuse fournit une indication correspondant à la détermination d'inverser ou de maintenir les états logiques des données de programme stockées dans la totalité des « n » cellules de mémoire du groupement.

8. Procédé de redondance selon la revendication 7, incluant en outre les étapes ci-dessous consistant à :
programmer les cellules de mémoire (1201 ; 1301 ; 1401) avec l'un des états logiques des données de programme et des états logiques inversés des données de programme ; et
programmer les cellules d'état d'inversion (1202a, 1202b ; 1302a, 1302b ; 1402a, 1402b, 1402c) avec la combinaison logique d'états logiques spécifiques et d'états logiques permanents.

9. Procédé de redondance selon la revendication 8, incluant en outre les étapes ci-dessous consistant à :
lire les cellules de mémoire (1201 ; 1301 ; 1401) ;
lire les cellules d'état d'inversion (1202a, 1202b ; 1302a, 1302b ; 1402a, 1402b, 1402c); et
inverser des données lues des cellules de mémoire (1201 ; 1301 ; 1401) lorsque la combinaison logique des états logiques spécifiques et des états logiques permanents indique que les données lues ont été programmées dans un état inversé.

10. Procédé de redondance selon la revendication 9, dans lequel l'étape d'inversion inclut les étapes ci-dessous consistant à :
exécuter une opération logique sur la combinaison logique des états logiques spécifiques et des états logiques permanents, en vue de fournir un signal de commande d'inversion, et
exécuter une opération d'inversion sur les données lues en réponse au signal de commande d'inversion.

11. Procédé de redondance selon la revendication 7, dans lequel les cellules d'état d'inversion (1202a, 1202b ; 1302a, 1302b ; 1402a, 1402b, 1402c) incluent deux cellules d'état d'inversion.

12. Procédé de redondance selon la revendication 7, dans lequel les cellules d'état d'inversion (1202a, 1202b ; 1302a, 1302b ; 1402a, 1402b, 1402c) incluent trois cellules d'état d'inversion.

13. Procédé de redondance selon la revendication 7, dans lequel la combinaison logique est une opération ET.

14. Procédé de redondance selon la revendication 7, dans lequel la combinaison logique est une opération « Ou exclusif », OUX.
